# EUROPÄISCHE PATENTSCHRIFT

(11) **EP 3 520 098 B1**
(45) Veröffentlichungstag und Bekanntmachung des Hinweises auf die Patenterteilung: **25.10.2023**
(21) Anmeldenummer: 17807707.9
(22) Anmeldetag: 27.09.2017
(51) Int. Cl.: G09F 9/33, G09F 3/20, G09F 3/02, G09F 3/10, G09F 23/10, G09F 23/00

(54) **DESTRUKTIONSLOSE INTEGRATION VON ELEKTRONIK**
NONDESTRUCTIVE INTEGRATION OF ELECTRONICS
INTÉGRATION NON DESTRUCTIVE DE COMPOSANTS ÉLECTRONIQUES

(30) Priorität: 27.09.2016 DE 102016118185
(43) Veröffentlichungstag der Anmeldung: 07.08.2019
(73) Patentinhaber: INURU GmbH, 12489 Berlin (DE)
(72) Erfinder: BARKOWSKI, Patrick, 12459 Berlin (DE); RATAJCZAK, Marcin, 13353 Berlin (DE)
(74) Vertreter: Hertin und Partner Rechts- und Patentanwälte PartG mbB
(86) Internationale Anmeldenummer: PCT/EP2017/074512
(87) Internationale Veröffentlichungsnummer: WO 2018/060256

(56) Entgegenhaltungen:
- EP-A1- 2 534 541
- EP-B1- 2 534 541
- WO-A1-2016/155887
- DE-A1-102010 032 839
- US-A1- 2002 011 786
- US-A1- 2003 006 411
- US-A1- 2007 039 503
- US-A1- 2008 111 806

## Beschreibung

Die Erfindung betrifft ein flächiges, dünnes, elektrisches, energieautarkes Bauteil, welches zumindest aus einer Anzeigevorrichtung und/oder einem Sensor, sowie einer Energiequelle oder eine Kombination aus den vorangegangenen besteht. Weiterhin betrifft die Erfindung eine Integration dieses elektrischen Bauteiles in bestehende Produkte, insbesondere Print- und Papierprodukte, ohne dass die Objekte beschädigt oder zerstört werden müssen.

### Hintergrund und Stand der Technik

Die Integration von Elektronik in Produkte bzw. Gegenstände des Alltages, in denen sie vorher nicht integriert waren, ermöglicht eine Vielzahl von Anwendungen. So kann z.B. die Integration einer Anzeigevorrichtung (LED, LCD) in Papier als Bestandteil von Werbung oder Verpackung als ein aufmerksamkeitserregendes Element fungieren.

DE 10 2010 032839 A1 ist der nächstliegende Stand der Technik. WO 2016/155887 A1, US 2008/111806 A1 und US 2002/011786 A1 offenbaren ähnliche Vorrichtungen.

Beispielsweise wird in der DE 20 2007 003 849 U1 eine Grußkarte offenbart, in welche eine LED zusammen mit einer Stromquelle und einem Schalter integriert wurde, um Lichteffekte und Bilder beim Öffnen und Schließen der Grußkarte zu generieren. Weiterhin wird in der EP 2 002 745 A1 ein Transportbehältnis, insbesondere ein Einkaufsbeutel, offenbart, in dessen Seitenfläche ein Leuchtmittel, insbesondere eine LED, integriert wurde. Die LED wird mit Hilfe einer Batterie angetrieben, um eine Werbebotschaft auszusenden.

Die bekannten Verfahren des Standes der Technik zur Integration der Elektronik in Produkte sind stets destruktiv. Hierbei ist mit dem Begriff destruktiv eine zumindest teilweise Beschädigung, Zerstörung oder Auftrennung einer Oberfläche der Produkte gemeint. So wird im Stand der Technik die Elektronik mit der Anzeigenvorrichtung meistens hinter eine bestehende Fläche des Produktes gebracht. Hierzu ist es notwendig, die Produktfläche aufzutrennen. Weiterhin muss die Produktfläche, damit die Anzeigenvorrichtung nach außen hin gut sichtbar ist, mit entsprechenden Öffnungen versehen werden. Anhand der Öffnungen kann der Nutzer auf einen Blick erkennen, dass das Produkt eine Elektronik z.B. eine Anzeigevorrichtung, wie beispielsweise eine LCD aufweist. Die Elektronik kann durch dieses Verfahren somit nicht nahtlos in das bestehende Erscheinungsbild des Produktes integriert werden.

Zudem müssen zur Gewährleistung der Funktionalität der Anzeigenvorrichtung weitere elektronische Bauelemente wie z.B. Batterien, Siliziumleiterplatten etc. auf der gegenüberliegenden Seite der Produktfläche mit separaten Bau- und Verbindungsteilen, wie insbesondere elektrisch leitenden Kabeln, installiert werden. Sowohl das Schneiden und Stanzen der Produktfläche, als auch die Integration der Elektronik selbst stellen separate Verfahrensschritte dar, welche die Kosten für die Integration von Elektronik mit bekannten Verfahren sehr kostenintensiv gestalten. Zum einen liegt dies daran, dass die Elektronik entweder vorab zusammengebaut und dann manuell oder unter Zuhilfenahme eines entsprechenden Bestückers auf das flexible Substrat (z.B. Papier) integriert werden muss. Oder aber die Elektronik wird an der Fläche des Produktes selbst durch Löten oder andere Prozesse installiert. Der Integrationsprozess konventioneller Elektronik in Produktflächen verlangt daher aufwendige Lötprozesse, um die einzelnen Komponenten der Elektronik zu verbinden. Weiterhin müssen die Komponenten der Elektronik auf der Rückseite der Produktfläche befestigt werden. Hierzu werden im Stand der Technik beispielsweise Klebstoff oder Klebebänder etc. verwandt.

Ein weiterer Nachteil bekannter Verfahren zur Integration von Elektronik in Produkten liegt darin, dass die Bestandteile nicht entsorg- und/oder recyclebar sind. Beispielsweise wird hierdurch eine Verwendung in Papierverpackungen erschwert. Durch die nur aufwendig trennbare Integration der Elektronik in die Papierverpackung wird die gesamte Papierverpackung zu nicht recyclebarem Müll. Weiterhin weisen konventionelle Elektronikkomponenten zumeist eine Dicke in einem Bereich von einigen Millimetern auf, nehmen einen zu großen Raum in der Verpackung oder auf dem Papier ein und verändern dadurch dessen Haptik.

### Aufgabe der Erfindung

Eine Aufgabe der Erfindung war es ein Verfahren und eine Vorrichtung bereitzustellen, welche die Nachteile des Standes der Technik beseitigen. Insbesondere war es eine Aufgabe der Erfindung, ein elektronisches Bauteil bereitzustellen, welches eine einfache und kostengünstige Integration von optischer Elektronik in Produkte erlaubt. Hierbei war es eine weitere Aufgabe, eine derartige Integration der optischen Elektronik zu ermöglichen, welche sich möglichst nahtlos in das Erscheinungsbild des Produktes einfügt.

### Zusammenfassung der Erfindung

Die erfindungsgemäße Aufgabe wird durch die unabhängigen Ansprüche 1 und 2 für ein elektronisches Bauteil, ein Produkt nach Anspruch 15, ein Verfahren zur Herstellung eines elektronischen Bauteiles nach Ansprüche 11 und 12 sowie der Verwendung des elektronischen Bauteiles nach Anspruch 14 zur Applikation auf Produkten gelöst. Die abhängigen Ansprüche betreffen bevorzugte Ausführungsformen der Erfindung.

Die Erfindung betrifft bevorzugt ein flächiges elektronisches Bauteil, umfassend eine Anzeigenvorrichtung, eine Energiequelle und eine Leiterbahn, wobei das Bauteil eine untere Lage eines nichtleitenden Substrats, eine mittlere Lage einer Elektronik, umfassend die Anzeigenvorrichtung, die Energiequelle und die Leiterbahn und eine obere Lage einer bedruckbaren Deckschicht umfasst.

Im Sinne der Erfindung bezeichnet ein flächiges elektronisches Bauteil bevorzugt ein elektronisches Gerät, welches sich durch seine Dimensionierung auszeichnet, wobei die Dicke des Bauteiles deutlich geringer ist als dessen Länge und/oder Breite.

Der Begriff flächig bezeichnet eine Dicke von weniger als 1 mm.

Ein elektronisches Bauteil von solch Dicke lässt sich besonders zuverlässig und somit günstig herstellen. Es kann ebenso bevorzugt sein, dass das Bauteil eine Dicke von bevorzugt weniger als 0,3 mm aufweist, während das Bauteil eine Länge und Breite im Bereich mehrere Zentimeter aufweist, sodass ein Verhältnis der Dicke zur Länge bzw. Breite des Bauteiles von mehr als 1:10, mehr als 1:50 oder mehr als 1:100 bevorzugt gegeben ist. Ein solches Bauteil trägt zur Miniaturisierung von optoelektronischen Bauelementen bei. Aufgrund der außergewöhnlichen Dünnheit kann eine besondere ästhetische Wirkung erzielt werden. Das flächige elektronische Bauteil ist weiterhin dadurch gekennzeichnet, dass dieses eine OLED-Anzeigevorrichtung

Eine OLED-Anzeigevorrichtung bezeichnet ein elektronisches Bauelement zur Generation von sichtbarem Licht mit organischen Leuchtdioden (OLEDs). OLEDs zeichnen sich durch eine besondere hohe Flexibilität und geringe Schichtdicke aus, sodass mit Hilfe dieser ein besonders dünnes Bauteil hergestellt werden kann. Weiterhin umfasst das flächige elektronische Bauteil bevorzugt eine Energiequelle, welche beispielsweise eine flache Batterie sein kann, welche elektrischen Strom zum Betrieb der Anzeigenvorrichtung bereitstellt. Eine galvanische Verbindung zwischen der Energiequelle und der Anzeigenvorrichtung wird bevorzugt mit Hilfe von Leiterbahnen durchgeführt. Im Sinne der Erfindung sind Leiterbahnen bevorzugt aus einem leitfähigen Material hergestellte Streifen, welche bevorzugt eine höhere Länge als Breite aufweisen und zur Verbindung von elektronischen Komponenten dienen. Bevorzugt weisen die Leiterbahnen eine geringe

Dicke von deutlich weniger als 0,3 mm auf und sind mit Hilfe von Druckverfahren erzeugt. Im Sinne der Erfindung werden die Komponenten Anzeigevorrichtung, Energiequelle und Leiterbahnen auch als elektronische Komponenten bezeichnet und bilden in ihrer Gesamtheit die Elektronik des Bauteils. Sollte das Bauteil in bevorzugten Ausführungsformen weitere elektronische Komponenten, wie z.B. Schalter, Sensoren etc. aufweisen, gehören diese ebenfalls zur Elektronik.

Das Bauteil umfasst somit eine Elektronik, welche autark, d.h. ohne die Notwendigkeit einer externen Energiezufuhr, die OLED Anzeigenvorrichtung, betreiben und zum Leuchten bringen kann.

Erfindungsgemäß ist das Bauteil in Schichten aufgebaut, wobei das elektronische, flächige Bauteil auch als ein Laminat aus verschiedenen Schichten aufgefasst werden kann. Das Bauteil umfasst bevorzugt drei Schichten. Eine untere Schicht stellt bevorzugt ein nichtleitendes Substrat, wie z.B. aus Papier oder Karton dar. Diese untere Schicht verleiht dem Bauteil eine Stabilität und ist bevorzugt dazu geeignet, das Bauteil auf eine Fläche von einem Produkt zu kleben. Es kann sich bei dem Bauteil auch um ein Produkt selbst handeln, d.h. zum Beispiel ein Printerzeugnis, wie beispielsweise die Seite eines Magazins handeln. In dem Falle kann das Substrat somit auch eine Fläche des Produktes, zum Beispiel eine Magazinseite, sein, auf welche die Elektronik aufgebracht wird. Die Rückseite, d.h. die Seite, auf der keine Elektronik aufgebracht ist, ist bedruckbar. Bevorzugt ist das Substrat hinreichend nichtleitend, sodass die auf das Substrat aufgebrachten elektronischen Komponenten nicht durch das Substrat selbst, sondern nur gezielt beispielsweise mit Hilfe von Leiterbahnen verbunden werden.

In der mittleren Lage umfasst das Bauteil bevorzugt die Elektronik. Wie obig ausgeführt, umfasst bevorzugt die minimale Ausführung der Elektronik für das Bauteil eine Anzeigenvorrichtung, eine Energiequelle und Leiterbahnen. Die Elektronik wird mit Hilfe von Druckverfahren aufgebracht. Diese Verfahren bedeuten ein Ersparnis an Zeit, Material, Arbeitsstufen und Kosten. Es kann aber auch bevorzugt sein, dass teilweise einige elektronische Komponenten, wie z.B. eine Batterie, nicht mit Hilfe von Druckverfahren aufgebracht werden, sondern platziert werden, während andere elektronische Komponente wie insbesondere die Leiterbahnen oder eine OLED als Anzeigenvorrichtung mit Hilfe von Druckverfahren aufgebracht werden. So kann ein besonders flexibler Aufbau mit einer leistungsstarken Energiequelle und energieeffizienten elektronischen Komponenten bereitgestellt werden. Der Begriff gedruckte Elektronik bezeichnet bevorzugt die Elektronik dieser mittleren Schicht des Bauteiles, wobei mindestens teilweise, bevorzugt vollständig, die elektronischen Komponenten mit Hilfe von Druckverfahren auf das Substrat aufgebracht wurden.

Auf die mittlere Lage, umfassend die Elektronik, wird bevorzugt eine dritte, obere Lage aufgebracht, welche eine bedruckbare Deckschicht ist. Im Sinne der Erfindung bezeichnet eine bedruckbare Deckschicht bevorzugt jede Schicht aus einem Material, welches anschließend in weiteren Druckverfahren gestaltet werden kann. Es ist besonders bevorzugt, dass die bedruckbare Deckschicht cellulosehaltige Materialien umfasst. Diese Materialien sind besonders kostengünstig und vielseitig einsetzbar. Besonders bevorzugte bedruckbare Deckschichten sind Papier, Transparentpapier, Brotpapier und/oder Folie. Diese Materialien sparen bei der Herstellung des Bauteils viele Arbeitsstufen ein, außerdem haben sie eine besondere ästhetische Wirkung. Die bedruckbare Deckschicht bewirkt zum einen einen wirksamen Schutz der Elektronik vor äußeren Einflüssen und erlaubt zum anderen eine optische Gestaltung des Bauteiles, sodass sich dieses optimal und nahezu nicht wahrnehmbar in eine Fläche eines Produktes einfügen kann. Die bedruckbare Deckschicht ist mindestens teilweise transluzent. D.h. die Deckschicht sollte derart gewählt werden, dass diese das Leuchtsignal der Anzeigenvorrichtung zumindest teilweise passieren lässt, sodass ein Verbraucher diese auch durch die Deckschicht hindurch wahrnehmen kann. So kann der gewünschte Leuchteffekt besonders wirkungsvoll erzielt werden. Es ist jedoch besonders bevorzugt, dass die Deckschicht lichtdurchlässig, jedoch nicht transparent, d.h. vollkommen blickdurchlässig ist, sodass das Licht der OLED an der Deckschicht gestreut wird. Überraschenderweise fungiert eine transluzente Deckschicht, also eine lichtdurchlässige, aber nicht blickdurchlässige Schicht, als ein Projektionsschirm oder - fläche für die OLED Anzeigenvorrichtung, wodurch die Bildgebung der Anzeigenvorrichtung projiziert werden kann. Dadurch erhält der Endnutzer das Gefühl, dass das Licht, die Bewegung, das Video oder sonstige Inhalte, welche durch die OLED Anzeigevorrichtung angezeigt werden, direkt auf der Deckschicht, also dem Schirm und/oder dem Papier angezeigt werden. So wird eine besondere ästhetische Wirkung erzielt. Durch die Bedruckung der Deckschicht können vorteilhafterweise aber gerade diejenigen elektronischen Komponenten, welche nicht sichtbar sein sollten, abgedeckt werden. Es kann auch bevorzugt sein, den Teil der Deckschicht zu bedrucken, welcher aufleuchten soll, d.h. oberhalb der Anzeigenvorrichtung. Dadurch erhält die OLED Anzeigevorrichtung eine Struktur und bindet sich nahtlos in ein Druckbild über. Zum Beispiel kann der Aufdruck einer Lampenstruktur eines Scheinwerfers über eine komplett weiße OLED ein sehr realistisches Abbild erzeugen. Der optische Effekt kann so mit größter Effektivität erzielt werden. Die Flächen der Deckschicht, welche leuchten soll, können bevorzugt im Druckbild weiß gelassen werden. Es kann aber auch besonders bevorzugt sein, die Flächen, welche durchscheinen sollen nicht oder nur lasierend (teilflächig in Mustern) zu bedrucken. Soll jedoch zum Beispiel ein rotes Bild auf einem Schwarzen Hintergrund erscheinen, wird bevorzugt der schwarze Hintergrund nicht vollflächig bedruckt, d.h. Farbpunkt an Farbpunkt, sondern in gewissen Strukturen, die einen besseren Lichtfluss gewährleisten. Hierzu kann es bevorzugt sein, Muster zu wählen, wie zum Beispiel Farbpunkt (z.B. Schwarz), Weiß, Farbpunkt, weiß, etc. Diese Muster können mit Quadraten, Linien oder in anderen Anordnungen umgesetzt werden. Vorteilhafterweise kann durch die Wahl der Muster der Grad der Lichtdurchlässigkeit gewählt werden. Ebenso kann die Effizienz des Lichteffekts bezüglich der verbrauchten Energie optimiert werden.

Die Bereitstellung des erfindungsgemäßen, flächigen elektronischen Bauteiles erlaubt auf besonders einfache Weise, Elektronik, umfassend eine Anzeigenvorrichtung, in ein Produkt zu integrieren und es wird eine Miniaturisierung erreicht. Zu diesem Zweck kann das autarke, elektronische Bauteil bevorzugt mit Hilfe von einem Kleber oder andere Haftvermittlern auf die Fläche eines Produktes aufgebracht werden. Dabei kann es bevorzugt sein, dass das elektronische Bauteil die gesamte Fläche des Produktes abdeckt. In diesem Fall wird durch die Bedruckung der Deckschicht die optische Gestaltung des Produktes erreicht und für einen Verbraucher ist nicht ersichtlich, dass auf dem Produkt eine Elektronik appliziert wurde. Es können so besonders wirkungsvolle Effekte erzielt werden. Es kann aber auch bevorzugt sein, dass das Bauteil eine kleinere Dimensionierung als die Produktfläche aufweist. So können Material und damit Kosten gespart werden. In dem Falle ist es jedoch bevorzugt, dass das Bauteil hinreichend dünn ist, so dass es sich dennoch zumindest nahezu nahtlos in die Fläche des Produktes eingliedert. So kann eine besondere ästhetische Wirkung erzielt werden.

Im Sinne der Erfindung wird unter dem Begriff Produkt bevorzugt jeder Gegenstand verstanden, insbesondere Nutzgegenstände oder Ziergegenstände. Hierbei umfasst der Begriff sowohl beispielsweise aktive Geräte als auch passive Gegenstände, welche verkauft werden sollen, als auch deren Verpackungen, welche zum Beispiel mit dem Bauteil verziert werden können. Auch Zeitungen, Papier, Karten usw. werden als Produkte im Sinne der Erfindung verstanden. Bevorzugte Anwendungsgebiete der Erfindung betreffen die Gestaltung von Printwerbung, Verpackungen, Point of Sale Aufstellern, Banknoten und viele mehr. Bevorzugt ist die Verwendung des elektronischen, flächigen Bauteiles somit nicht auf die Anwendung von spezifischen Gegenständen beschränkt, sondern für eine Vielzahl unterschiedlicher Produkte geeignet. Ein erfindungsgemäßer Vorteil des elektronischen, flächigen Bauteiles ist es gerade, die Integration von Elektronik mittels einfachem Labeling oder Kleben ohne komplexe und destruktive Integrationsschritte zu erreichen. Hierdurch kann auch Elektronik in Produkte integriert werden, deren Flächen insbesondere gegenüber destruktiven Integrationsschritten besonders sensitiv sind, wie zum Beispiel Getränkebehältnisse.

Es war überraschend, dass aufgrund der bevorzugten Ausführungsform mit der Zusammensetzung des Bauteils mittels dünner Schichten, ein besonders dünnes, flächiges elektronisches Bauteil bereitgestellt werden konnte. Dadurch ist das Bauteil besonders flexibel und somit zur Integration in ein Printerzeugnis besonders gut geeignet. Darüber hinaus wird eine besondere ästhetische Wirkung erzielt. Des Weiteren ist ein solches Bauteil trotz der dünnen Ausführung besonders robust, zuverlässig und wartungsarm.

Es kann auch bevorzugt sein, dass die Elektronik direkt auf eine Rückseite der Deckschicht aufgebracht wird, in diesem Fall ist ein nichtleitendes Substrat vorteilhafterweise nicht notwendig bzw. die Deckschicht fungiert als ein nichtleitendes Substrat für die Elektronik.

In einer bevorzugten Ausführungsform betrifft die Erfindung daher ein flächiges elektronisches Bauteil umfassend eine Anzeigenvorrichtung, eine Energiequelle und eine Leiterbahn, wobei eine Lage einer Elektronik, umfassend die Anzeigenvorrichtung, die Energiequelle und die Leiterbahn auf einer Lage einer bedruckbaren Deckschicht aufgebracht ist, welche ein nichtleitendes Substrat ist. Auch in diesem Fall ist eine destruktionslose Integration in das zu bestückende Produkt möglich. Diese bevorzugte Ausführungsform zeichnet sich durch ihre besondere Einfachheit aus. Es kann des Weiteren besonders dünn und damit flexibel gestaltet werden.

In einer bevorzugten Ausführungsform der Erfindung ist das flächige elektronische Bauteil dadurch gekennzeichnet, dass das Bauteil eine Dicke von weniger als 0,3 mm aufweist. Vorteilhafterweise wird durch den Schichtaufbau des Bauteiles ermöglicht, dass dieses nur eine sehr geringe Dicke von weniger als 0,3 mm aufweist. Hierdurch lässt sich das Bauteil auf ein Produkt applizieren, d.h. zum Beispiel kleben, sodass dieses kaum haptisch oder durch ungewollte optische Brüche wahrnehmbar ist. Die Wahrnehmbarkeit bezeichnet bevorzugt ein ungewolltes Erscheinungsbild, welches den Kunden darauf stößt, dass in das Produkt Elektronik integriert wurde, nicht jedoch die gewollte optische Signalgebung durch die Anzeigenvorrichtung. Es wird so eine hohe Miniaturisierung erzielt, welche des Weiteren eine besondere ästhetische Wirkung zur Folge hat.

In einer weiteren bevorzugten Ausführungsform ist das flächige elektronische Bauteil dadurch gekennzeichnet, dass die Elektronik mindestens teilweise mit einem Druckverfahren ausgewählt aus einer Gruppe umfassend Inkjet, Siebdruck, Flexodruck und/oder Offset-Druck aufgebracht wurde. Diese Verfahren bedeuten ein Ersparnis an Zeit, Material, Arbeitsstunden und Kosten. Mindestens teilweise meint in der bevorzugten Ausführungsform, dass mindestens einiger der Komponenten der Elektronik mit einem der genannten Druckverfahren aufgebracht wurde. Dies betrifft bevorzugt die Leiterbahnen. Beispielsweise können die Leiterbahnen mit den genannten Druckverfahren auf das Substrat aufgebracht werden. Anschließend kann die Anzeigenvorrichtung, wie zum Beispiel eine OLED gedruckt bzw. platziert werden, oder auch die Energiequelle, wie eine Batterie, gedruckt bzw. platziert werden, wie auch weitere elektronische Komponenten wie Schalter, Sensoren auf die Leiterbahnen gedruckt oder platziert werden können. Hierdurch ist es möglich mit einfachen Verfahrensschritten eine mindestens teilweise gedruckte Elektronik zu erhalten, welche sich durch eine besonders geringe Dicke und hohe Biegsamkeit auszeichnet. Aufwendige Verlötungsprozesse, welche im Stand der Technik zumeist zur Integration von konventioneller Elektronik in Produkte notwendig sind, entfallen vorteilhafterweise.

In einer weiteren bevorzugten Ausführungsform der Erfindung ist das flächige elektronische Bauteil dadurch gekennzeichnet, dass die Anzeigenvorrichtung eine organische Leuchtdiode (OLED) ist. OLEDs bestehen zumeist aus einem Sandwich Aufbau, wobei sich zwischen zwei Elektroden zumeist mehrere Schichten organische halbleitender Materialien befinden. Insbesondere umfasst eine OLED eine oder mehrere Emitterschichten (engl. *emitter layer* EL) in welcher oder in welchen elektromagnetische Strahlung, bevorzugt im sichtbaren Bereich, durch eine Rekombination von Elektronen mit Elektronenlöchern erzeugt wird. Die Elektronen und Elektronenlöcher werden durch jeweils eine Kathode bzw. Anode bereitgestellt, wobei bevorzugt sogenannte Injektionsschichten durch eine Absenkung der Injektionsbarriere den Prozess erleichtern. OLEDS verfügen daher zumeist über Elektronen- bzw. Lochinjektionsschichten. Des Weiteren verfügen OLEDs in der Regel über Elektronen- und Lochtransportschichten (engl. *hole transport layer* (HTL) oder *electron transport layer* (ETL)), welche die Diffusionsrichtung der Elektronen und Löcher zur Emitterschicht unterstützen. Bei OLEDs sind diese Schichten aus organischen Materialien aufgebaut, bei hybriden optoelektronischen Bauteilen können die Schichten teilweise aus organischen teilweise auch aus anorganischem Materialien bestehen.

Im Vergleich zu herkömmlichen anorganischen LEDs zeichnen sich OLEDs und hybride LEDs durch einen dünnen und flexiblen Schichtaufbau aus. Aus diesem Grunde lassen sich OLEDs und hybride LEDs deutlich vielfältiger als klassische anorganische LEDs einsetzen. Aufgrund der Biegsamkeit sind OLEDs beispielsweise für Bildschirme, elektronisches Papier oder die Innenbeleuchtung hervorragend einsetzbar. Durch diese vorteilhaften Eigenschaften sind OLED auch besonders gut als Anzeigenvorrichtung für das elektronische Bauteil geeignet, da sie eine geringe Schichtdicke bei hoher Flexibilität und ausgezeichneter Qualität der Leuchtsignale erlauben.

Für das erfindungsgemäße Bauteil sind einer Reihe von verschiedenen OLEDs geeignet. Bevorzugt sind die OLEDs durch einen Dünnschichtaufbau gekennzeichnet. Wie beispielsweise aus der WO 2011/018356 oder WO 2014/048971 bekannt, können die OLEDs auch verkapselt werden, um die elektrisch aktiven Bereiche der OLED insbesondere gegenüber Wasserdämpfen oder Sauerstoff zu schützen, da das Eindringen dieser Permeanten die Lebenszeit der OLEDs deutlich erniedrigt.

In einer bevorzugten Ausführungsform ist das flächiges elektronisches Bauteil dadurch gekennzeichnet, dass
die OLED eine Kathode, eine Anode und ein Schichtsystem zwischen der Kathode und der Anode aufweist, umfassend
   - mindestens eine kathodennahe Elektroneninjektionsschicht,
   - mindestens eine Elektronentransportschicht
   - mindestens eine optisch aktive Schicht
   - mindestens eine Lochtransportschicht
   - mindestens eine anodennahe Lochinjektionsschicht
wobei die mindestens eine Elektroneninjektionsschicht und die mindestens eine Lochinjektionsschicht diffusionslimitierend gegenüber Wasser und/oder Sauerstoff sind und die mindestens eine Elektronentransportschicht und die mindestens eine Lochtransportschicht eine Diffusionsbarriere gegenüber Wasser und/oder Sauerstoff darstellen.

Die Kathode dient bevorzugt als Elektronenlieferant. Bevorzugt weist die Kathode einen geringen Flächenwiderstand auf, um eine möglichst gleichmäßige Injektion der Elektronen über die Fläche der OLED zu ermöglichen.

Die Elektroneninjektionsschicht hingegen erfüllt die Funktion die Austrittsarbeit der Kathode und der folgenden Schicht, der Elektronentransportschicht, anzugleichen. Die Austrittsarbeit (engl. *work function*) entspricht bevorzugt der Energie, die mindestens aufgewandt werden muss, um ein Elektron aus einem ungeladenen Festkörper herauszulösen. Durch das Angleichen der Austrittsarbeit der Kathode zu der Elektronentransportschicht wird die Spannung herabgesetzt, die notwendig ist, um Elektronen von der Kathode in die Elektronentransportschicht einzuspeisen bzw. zu injizieren und so die Effektivität der OLED erhöht.

Die Elektronentransportschicht dient dem gerichteten Elektronentransport zwischen Kathode und der optisch aktiven Schicht, d.h. der bevorzugten Ausführungsform der Emitterschicht. Dazu sollte die Elektronentransportschicht bevorzugt eine genügende Beweglichkeit oder Mobilität von Elektronen (bevorzugt von 10⁻⁶ bis 100 cm²/ (V * sec)) aufweisen. In diesem Bereich unterstützt die Elektronentransportschicht einen besonders effizienten Betrieb der OLED. Zusätzlich sollte bevorzugt das Ladungstransportenergielevel, d.h. das Leitungsband bzw. LUMO (engl. *lowest unnoccupied molecular orbital*) der Elektronentransportschicht, zwischen dem Energielevel des Emittermaterials und der Austrittsarbeit der Kathode liegen, d.h., dass nach Leisten der Austrittsarbeit keine zusätzliche Energie zum Transport der Elektronen vor der Rekombination mit den Löchern nötig ist.

Die Emitterschicht besteht bevorzugt aus halbleitenden organischen Polymeren oder Molekülen, die bei elektrischer Anregung Licht im sichtbaren Bereich produzieren, d.h. bevorzugt in einem Wellenlängenbereich von 400 bis 700 nm. So kann eine besondere ästhetische Wirkung auf effiziente Weise erzeugt werden. In der Emitterschicht rekombinieren bevorzugt die Elektronen der Kathode mit den Löchern der Anode zu Exzitonen. Bevorzugt überwiegt dabei der Anteil an Singlet-Exzitonen, sodass es zu einer effektiven Lichterzeugung kommt.

Die Lochtransportschicht ist das Pendant zur Elektronentransportschicht und dient bevorzugt dem Transport von (Elektronen-)Löchern aus der Anode zur Emitterschicht. Bevorzugt sollte die Lochtransportschicht daher eine genügende Beweglichkeit oder Mobilität von Elektronenlöcher, bevorzugt von 10⁻⁶ bis 100 cm²/ (V * sec), aufweisen. Zusätzlich sollte bevorzugt das Energielevel für den Transport der Elektronenlöcher, d.h. das Leitungsband bzw. HOMO (engl. *highest occupied molecular orbital*) der Lochtransportschicht zwischen dem Energielevel des Emittermaterials und der Austrittsarbeit der Anode liegen.

Die Lochinjektionsschicht besteht wie ihr Pendant auf der Kathodenseite (die Elektroneninjektionsschicht) vorzugsweise aus stark dielektrischen Polymeren und ist bevorzugt ein Isolator. Bevorzugt dient die Lochinjektionsschicht dazu die Energieniveaus der Anode und der folgenden Schicht, der Lochtransportschicht anzugleichen, um eine effektive Injektion von Elektronenlöchern zu gewährleisten.

Die Anode ist bevorzugt der Elektronenlochlieferant und weist daher bevorzugt eine deutlich höhere Austrittsarbeit als die Kathode auf. Weiterhin ist es bevorzugt, dass die Anode eine hohe Flächenleitfähigkeit für Löcher aufweist. Zudem kann es bevorzugt sein, dass das Anodenmaterial transparent ist, um vorzugsweise durch die Anode den Lichtaustritt zu ermöglichen.

Für diese bevorzugten Ausführungsform wurde erkannt, dass eine Verlängerung der Lebensdauer der OLED insbesondere in einem Schutz der optisch aktiven Schicht, d.h. der lichterzeugenden Schicht, vor dem schädlichen Einfluss von Wasser bzw. Wasserdämpfen sowie Sauerstoff erfolgen sollte. Anstatt einer Verkapselung der gesamten OLED werden elektrisch aktiven Schichten genutzt, um eine Blockadefunktion gegenüber Wasser bzw. Sauerstoff zu erfüllen.

Hierzu ist die mindestens eine Elektroneninjektionsschicht und die mindestens eine Lochinjektionsschicht diffusionslimitierend gegenüber Wasser und/oder Sauerstoff, wobei die mindestens eine Elektronentransportschicht und die mindestens eine Lochtransportschicht eine Diffusionsbarriere gegenüber Wasser und/oder Sauerstoff bilden. Durch diese duale Funktionalität der elektrisch aktiven Schichten sowohl als Permeationsbarrieren für Wasser und Sauerstoff, als auch zur Unterstützung des gerichteten Stromes der Ladungsträger, kann die bevorzugte OLED deutlich kompakter konstruiert werden, wodurch das elektronische Bauteil besonders flach konstruiert werden kann. Insbesondere gegenüber der aus dem Stand der Technik bekannten Verkapselung kann die OLED geschützt werden, ohne die Flexibilität des Bauteils einzuschränken. Gleichzeitig wird die Anfälligkeit gegenüber zerstörerischen Gaseinschlüssen und Verarbeitungsfehlern der Verkapselung beseitigt.

Im Sinne der Erfindung wird unter der Eigenschaft "diffusionslimitierend gegenüber Wasser und/oder Sauerstoff" bevorzugt verstanden, dass die entsprechenden Injektionsschichten die Diffusion von Wasser und/oder Sauerstoffmolekülen deutlich reduzieren. So kann es bevorzugt sein, dass durch die diffusionslimitierenden Schichten die Weglänge der Wasser und Sauerstoffmoleküle in der Schicht erhöht wird, sodass die Moleküle nicht zu den optisch aktiven Schichten gelangen.

In einer bevorzugten Ausführungsform weisen die diffusionslimitierenden Schichten eine Wasserdampftransmissionsrate (WVTR) von weniger als 1 g/(m^{2*}d) und eine Sauerstofftransmissionsrate (OTR) von weniger als 1 cm³/(m^{2*}d) auf.

Im Sinne der Erfindung wird unter der Eigenschaft "Diffusionsbarriere" bevorzugt verstanden, dass die entsprechenden Elektronen- bzw. Lochtransportschichten die Permeation von Wasser- und/oder Sauerstoffmolekülen verhindern bzw. deutlich reduzieren. In einer bevorzugten Ausführungsform weisen die Elektronen- bzw. Lochtransportschichten als Diffusionsbarrieren eine Wasserdampftransmissionsrate (WVTR) von weniger als 0,1 g/(m^{2*}d) und eine Sauerstofftransmissionsrate (OTR) von weniger als 0,1 cm³/(m^{2*}d) auf.

Es ist jedoch besonders bevorzugt, dass die Blockadeeigenschaften der elektrisch aktiven Schichten zusammen mit den Elektroden Bedingungen genügen, welche einen effektiven Schutz der optisch aktiven Schicht vor Permeation von Wasser bzw. Sauerstoff gewährleisten. Daher kann es auch bevorzugt sein, dass in der bevorzugten OLED eine Schichtkombination aus einer Kathode, der mindestens einen Elektroneninjektionsschicht und der mindestens einen Elektronentransportschicht eine Wasserdampftransmissionsrate (WVTR) von weniger als 0,01 g/(m^{2*}d) und eine Sauerstofftransmissionsrate (OTR) von weniger als 0,01 cm³/(m^{2*}d) aufweist und/oder eine Schichtkombination aus einer Anode, der mindestens einen Lochinjektionsschicht und der mindestens einen Elektronentransportschicht eine Wasserdampftransmissionsrate (WVTR) von weniger als 0,01 g/(m^{2*}d) und eine Sauerstofftransmissionsrate (OTR) von weniger als 0,01 cm³/(m^{2*}d) aufweisen.

Es wurde erkannt, dass bevorzugt nicht die einzelnen diffusionslimitierenden Schichten bzw. Diffusionsbarrieren quantitativen Blockadeeigenschaften genügen müssen, sondern insbesondere die Schichtkombination bevorzugt aus der Elektrode und den elektrisch aktiven Schichten bis zur optisch aktiven Schicht. Hierbei kann es bevorzugt sein, dass bereits die Kombination aus einer Elektrode sowie einer Injektionsschicht und einer Transportschicht bevorzugt eine WVTR bzw. OTR von weniger als 0,01 g/(m^{2*}d) bzw. weniger als 0,01 cm³/(m^{2*}d) aufweist. Es kann aber auch bevorzugt sein, dass das Bauelement mehrere bevorzugt alternierende Injektionsschichten und Transportschichten umfasst, wobei die Schichtkombination beispielsweise der Kathode mit den gesamten Elektroneninjektionsschichten und Elektronentransportschichten eine WVTR bzw. OTR von weniger als 0,01 g/(m^{2*}d) bzw. weniger als 0,01 cm³/(m^{2*}d) aufweist. Gleiches gilt entsprechend für die anderen elektrisch aktiven Schichten. D.h., es kann auch bevorzugt sein, dass die Schichtkombination der Anode mit den gesamten Lochinjektionsschichten und Lochtransportschichten eine WVTR bzw. OTR von weniger als 0,01 g/(m^{2*}d) bzw. weniger als 0,01 cm³/(m^{2*}d) aufweist.

Überraschenderweise führen die genannten Werte der WVTR bzw. OTR für die Schichtkombinationen von weniger als 0,01 g/(m^{2*}d) bzw. weniger als 0,01 cm³/(m^{2*}d) zu einem besonders effektiven Schutz der optisch aktiven Schichten. So erhöhen sich für die bevorzugte Ausführungsform die Lebensdauern der bevorzugten Leuchtdioden erheblich.

Diese Ausführungsform mit den vorgenannten Werten stellt aufgrund der starken, synergistischen Barriereeigenschaften, die sich durch die Kombination der einzelnen Schichten ergeben und deren Wirkung stärker als die Summe der Barriereeigenschaften der einzelnen Schichten ist, ein besonders wartungsfreies Bauelement dar.

Die hier vorgestellte Ausführungsform hat sich des Weiteren als besonders wenig fehleranfällig bei Papierdruck erwiesen.

Es kann ebenfalls bevorzugt sein, dass das optoelektronisches Bauelement dadurch gekennzeichnet ist, dass eine Schichtkombination aus einer Kathode, der mindestens einen Elektroneninjektionsschicht und der mindestens einen Elektronentransportschicht eine Wasserdampftransmissionsrate (WVTR) von weniger als 0,1 g/(m^{2*}d) und eine Sauerstofftransmissionsrate (OTR) von weniger als 0,1 cm³/(m^{2*}d) aufweist und/oder eine Schichtkombination aus einer Anode, der mindestens einen Lochinjektionsschicht und der mindestens einen Elektronentransportschicht eine Wasserdampftransmissionsrate (WVTR) von weniger als 0,1 g/(m^{2*}d) und eine Sauerstofftransmissionsrate (OTR) von weniger als 0,1 cm³/(m^{2*}d) aufweist. Hierbei kann es bevorzugt sein, dass bereits die Kombination aus einer Elektrode sowie einer Injektionsschicht und einer Transportschicht bevorzugt eine WVTR bzw. OTR von weniger als 0,1 g/(m^{2*}d) bzw. weniger als 0,1 cm³/(m^{2*}d) aufweist. Es kann aber auch bevorzugt sein, dass das Bauelement mehrere bevorzugt alternierende Injektionsschichten und Transportschichten umfasst, wobei die Schichtkombination beispielsweise der Kathode mit den gesamten Elektroneninjektionsschichten und Elektronentransportschichten eine WVTR bzw. OTR von weniger als 0,1 g/(m^{2*}d) bzw. weniger als 0,1 cm³/(m^{2*}d) aufweist. Gleiches gilt entsprechend für die anderen elektrisch aktiven Schichten. D.h., es kann auch bevorzugt sein, dass die Schichtkombination der Anode mit den gesamten Lochinjektionsschichten und Lochtransportschichten eine WVTR bzw. OTR von weniger als 0,1 g/(m^{2*}d) bzw. weniger als 0,1 cm³/(m^{2*}d) aufweist.

Durch die Erkenntnis, dass es für bestimmte Ausführungsformen ausreichend sein kann, genannte Werte für die Schichtkombinationen zu realisieren, können besonders dünne Schichten verwendet werden, um die gewünschten Funktionalitäten zu erzielen.

Überraschenderweise führen die genannten Werte der WVTR bzw. OTR für die Schichtkombinationen von weniger als 0,1 g/(m^{2*}d) bzw. weniger als 0,1 cm³/(m^{2*}d) zu einem Bauelement mit besonders zuverlässig im Voraus bestimmbaren elektrischen Eigenschaften, welches gleichzeitig ausreichend vor Sauerstoff und Wasser geschützt ist. Es können des Weiteren bei gleichzeitig guten Schutzeigenschaften und somit langer Lebensdauer des Bauelements besonders dünne Schichten verwendet werden. Somit wird ein überraschend langlebiges und flexibles Bauelement realisiert.

Ebenso können auf diese Weise lichtemittierenden Bauelemente mit besonders vorteilhaften ästhetischen Eigenschaften (optische Brillanz) realisiert werden. So können lichtemittierenden Bauelemente mit den vorstehend genannten Eigenschaften beispielsweise auch für ganz dünnes Papier, wie beispielsweise das von Tageszeitungen, verwendet werden, um einen optischen Effekt (bspw. blinkende Lampen für Autowerbung) zu erzielen.

Unter der Wasserdampftransmissionsrate (WVTR) wird bevorzugt ein Messwert verstanden für die Durchlässigkeit von Wasserdampf bzw. Wassermoleküle durch die einzelne Schicht bzw. Schichtkombination. Zur Ermittlung des WVTR-Wertes wird bevorzugt die Masse der Wassermoleküle, welche innerhalb von 24 Stunden durch eine Fläche der Schicht diffundieren bestimmt. Vorliegend wird als bevorzugte Einheit die WVTR in g/(m^{2*}d) angegeben. Wobei die SI-Einheiten g für Gramm, d für Tag, d.h. 24 Stunden, und m² für Quadratmeter der Fläche der Schicht bzw. Kombinationsschicht steht.

Analog wird unter der Sauerstofftransmissionsrate (OTR) bevorzugt ein Messwert verstanden für die Durchlässigkeit von Sauerstoffmolekülen durch die einzelne Schicht bzw. Schichtkombination darstellt. Zur Ermittlung des OTR-Wertes wird bevorzugt das Gasvolumen der Sauerstoffmoleküle, welche innerhalb von 24 Stunden durch eine Fläche der Schicht diffundieren bestimmt. Vorliegend wird als bevorzugte Einheit die OTR in cm³/(m^{2*}d) angegeben. Wobei die SI-Einheiten cm³ für Kubikzentimeter, also dem Volumen der diffundierten Sauerstoffmoleküle steht, d für Tag, d.h. 24 Stunden, und m² für Quadratmeter, d.h. der Fläche der Schicht bzw. Kombinationsschicht, stehen.

Der Fachmann weiß wie die OTR und WVTR von Dünnschichten experimentell bestimmbar sind und kann daher die Schichten entsprechend dieser Eigenschaften routinemäßig auswählen. Experimentelle Tests zur Bestimmung der OTR und WVTR von dünnen Schichten von optoelektronischen Bauelementen werden beispielsweise von der American Society for Testing and Materials (ASTM) unter der ASTM D1653-13 mit dem Titel Standard Test Methods for Water Vapor Transmission of Organic Coating Films offenbart. Das Dokument für die Beschreibung der Tests ließ sich am 12.09.2016 unter https://www.astm.org/Standards/D1653.htm runterladen.

Besonders durch die Auswahl geeigneter Materialien und Schichtdicken, welche für die mindestens eine Elektronen- bzw. Lochtransportschicht zum einen zu den vorgenannten elektrischen Eigenschaften, zum anderen zu den gewünschten Barriereeigenschaften führt, kann ein Bauelement mit den gewünschten optoelektronischen Eigenschaften realisiert werden, welches gleichzeitig eine lange Lebensdauer aufweist. Des Weiteren kann die Leistungsfähigkeit des Bauelements erhöht werden.

In einer bevorzugten Ausführungsform ist die bevorzugte OLED dadurch gekennzeichnet, dass die mindestens eine Elektronentransportschicht ein dotiertes Metalloxid bevorzugt ein dotiertes Zinkoxid umfasst, wobei die Dotierung bevorzugt mit Aluminium, Alkali, Erdalkali, Metallocenen und/oder organischen n-Dotanten erfolgt und die Elektronentransportschicht besonders bevorzugt ein Aluminiumzinkoxid umfasst. Überraschenderweise zeichnen sich Elektronentransportschichten aus diesen Materialien, insbesondere aus einem dotierten Aluminiumzinkoxid, durch eine besonders gute Diffusionsbarriere gegenüber Wasser- und Sauerstoffmolekülen aus und weisen durch die Dotierung zudem optimale elektrische Eigenschaften auf. Es ist besonders bevorzugt, dass die Elektronentransportschicht aus einem der vorgenannten Materialien besteht und dabei ein LUMO zwischen 3 - 4 eV und eine Elektronenmobilität zwischen 10⁻⁶ cm²/(V*s) und 100 cm²/(V*s) aufweist. Dem Fachmann ist bekannt, wie er Materialien mit den genannten Parametern, ohne erfinderisch tätig zu werden, bereitstellen kann.

In einer bevorzugten Ausführungsform der Erfindung ist die bevorzugte OLED dadurch gekennzeichnet, dass die mindestens eine Lochtransportschicht ein dotiertes Metallthiocyanat, bevorzugt ein dotiertes Kupferthiocyanat und/oder ein dotiertes Metalloxid, bevorzugt ein dotiertes Zinkoxid umfasst. Diese Materialien lassen sich durch eine entsprechende Dotierung besonders vorteilhaft an die gewünschten Eigenschaften anpassen. Außerdem verfügen sie über die gewünschten Barriereeigenschaften gegenüber Sauerstoff und Wasser. Des Weiteren sind diese Materialien sehr robust und tragen so zur Herstellung eines zuverlässigen Bauelements bei. Bevorzugt werden die Materialien dotiert mit einem Metallthiocyanat. Metallthiocyanate eignen sich besonders gut zum Dotieren. Darüber hinaus ist mit ihnen ein breites Spektrum an durch Dotierung einstellbaren Eigenschaften erzielbar. Die Metallthiocyanate werden bevorzugt ausgewählt aus einer Gruppe umfassend Natriumthiocyanat, Kaliumthiocyanat, Silberthiocyanat, Wolframthiocyanat, Vanadiumthiocyanat, Molybdänthiocyanat, Kupferthiocyanat und/oder anderen Übergangsmetallthiocyanaten. Dotierungen ausgewählt aus vorstehender Gruppe erlauben das zielgenaue Einstellen gewünschter elektrische Eigenschaften. Im Einzelfall können sogar synergistische Effekte aufgrund einer weiteren Verbesserung der ohnehin guten Barriereeigenschaften des dotierten Grundmaterials erzielt werden. Es kann ebenso vorteilhaft sein, mit einem Metalloxid zu dotieren. Metalloxide zeichnen sich durch eine besonders unkomplizierte und daher zuverlässige Verarbeitbarkeit aus. Bevorzugt werden zur Dotierung Metalloxide ausgewählt aus einer Gruppe umfassend Wolframoxid, Vanadiumoxid, Nickeloxid, Kupferoxid, Molybdänoxid und/oder anderen Übergangsmetalloxiden verwendet. Diese zeichnen sich beim Dotieren durch eine große Effektivität aus. Zu Ihrer Verarbeitung sind nur wenige Arbeitsschritte nötig. Es kann aber auch bevorzugt sein, mit Halogenen wie Fluor, Chlor, Brom und lod zu dotieren. Diese zeichnen sich durch ihre ausgeprägte chemische Reaktivität sowie durch ihre hohen Vorkommen in der Natur aus.

Für die Lochtransportschicht ist es somit bevorzugt ein Metallthiocyanat, besonders bevorzugt ein Kupferthiocyanat oder aber ein Metalloxid, besonders bevorzugt ein Zinkoxid, zu dotieren. Der Fachmann weiß, dass eine Dotierung im Kontext von optoelektronischen Bauelementen bevorzugt das Einbringen von Fremdatomen, den Dotanten, in eine Schicht meint, wobei die eingebrachte Menge in der Regel im Vergleich zum Trägermaterial geringer ist. D.h. es kann bevorzugt sein, dass der Masseanteil der Dotanten weniger als 10%, bevorzugt weniger als 1%, der Gesamtschicht beträgt. Es kann aber auch bevorzugt sein, dass der Masseanteil der Dotanten bis zu 40% der Gesamtschicht beträgt. Bei der sogenannten p-Dotierung werden Elektronen-Akzeptoren dotiert, wohingegen bei der sogenannten n-Dotierung Elektronen-Donatoren dotiert werden. Für die Lochtransportschicht ist es bevorzugt Materialien auszuwählen, welche starke Akzeptoreigenschaften aufweisen und bevorzugt ein LUMO in der Nähe des HOMOs von dem Träger des Metallthiocyanat oder Metalloxids, bevorzugt des Kupferthiocyanats oder Zinkoxid, aufweisen. Ein organischer p-Dotant kann bevorzugt zum Beispiel auch Tetrafluorotetracyanochinodimethan oder auch Hexaazatriphenylenehexacarbonitrile sein. Diese haben sich als besonders brauchbar erwiesen. Sie können zur weiteren Vorteilen wie höhere Leistungsfähigkeit und Zuverlässigkeit sowie zu einer hohen Ausbeute führen.

Es ist besonders bevorzugt als Träger der Lochtransportschicht Kupferthiocyanat oder Zinkoxid zu verwenden mit den o.g. geeigneten Dotanten.

Diese vorgenannten Materialien für die Lochtransportschichten erlauben, insbesondere unter Verwendung von Kupferthiocyanat oder Zinkoxid, besonders effektiv eine Permeation von Wasser oder Sauerstoff zu verhindern und gleichzeitig ausgezeichneten elektrischen Eigenschaften zum Transport der Elektronenlöcher bereitzustellen.

In einer bevorzugten Ausführungsform der Erfindung ist das optoelektronische Bauelement dadurch gekennzeichnet, dass die mindestens eine Elektroneninjektionsschicht dielektrische Polymere umfasst. Diese weisen sich durch eine besondere Robustheit aus, wodurch ein langlebiges Bauteil überzeugt werden kann. Durch ihre guten Barriereeigenschaften entstehen Synergien, die sich darüber hinaus positiv auf die Langlebigkeit auswirken. Es ist besonders bevorzugt, hydrophile Polymere und/oder Polyelektrolyte zu verwenden. Diese lassen besonders leicht verarbeiten und bedeuten so eine Ersparnis an Zeit Material und Arbeitsstufen und dementsprechend an Kosten. Ganz besonders bevorzugt sind Polymere ausgewählt aus einer Gruppe umfassend Poly-Oxazoline, Polymethacrylate, Polyacrylamide, Polyethylenoxide, Polyacrylsäuren, Polyacrylate, Polyvinylpyrolidon sowie Co-Polymere dieser Gruppe. Diese haben sich als besonders brauchbar erwiesen und zeichnen sich durch überlegene elektrische Eigenschaften aus. Insbesondere ist der Gebrauch von Polyvinylalkohol, Polyethylenimin oder ethoxyliertes Polyethylenimin bevorzugt, denn sie führen zu einer weiteren Verbesserung und Leistungssteigerung des Bauelements.

Die vorgenannten Materialien sind besonders geeignet, um die elektrische Funktion der Injektionsschichten für Elektronen zu gewährleisten. So können die Elektronen als Ladungsträger den Quanteneffekt des "Tunnelns" nutzen und von der Kathode in die Elektronentransportschicht springen. Die vorgenannten dielektrischen Polymere erzeugen bevorzugt entsprechende Oberflächendipole und vermindern so die Injektionsbarriere für Elektronen. Gleichermaßen wird die Beweglichkeit von Sauerstoff- und Wassermolekülen in den Schichten überraschend stark vermindert bzw. eingeschränkt. Somit erlauben die vorgenannten Materialien die bevorzugten Werte für die OTR von weniger als 1 cm³/(m^{2*}d) und für die WVTR von weniger als 1 g/(m^{2*}d) besonders zuverlässig umzusetzen.

In einer bevorzugten Ausführungsform der Erfindung ist das optoelektronische Bauelement dadurch gekennzeichnet, dass die mindestens eine Lochinjektionsschicht dielektrische Polymere umfasst. Diese weisen überlegene Barriereeigenschaften auf und erhöhen so die Zuverlässigkeit. Diese sind bevorzugt Polymere mit funktionellen Gruppen ausgewählt aus eine Gruppe umfassend -CN, -SCN, -F, -Cl, -I und/oder -Br, welche besonders robust und wartungsfrei sind. Dabei umfasst die mindestens eine Lochinjektionsschicht besonders bevorzugt Polyvinylidenefluorid (PVDF), Polyvinylidenechlorid (PVDC), Polyacrylonitril (PAN) und/oder Co-Polymere dieser, welche eine Verbesserung und Leistungssteigerung des Bauelements bewirken.

Die vorgenannten Materialien sind besonders geeignet, um die elektrische Funktion der Injektionsschichten für Elektronenlöcher zu gewährleisten. Insbesondere erfüllen die vorgenannten Polymere die bevorzugte Injektionseigenschaft d.h. eine Erhöhung der Austrittsarbeit für Elektronen an den Kontaktflächen zur Injektionsschicht und damit eine effektive Lochinjektion. Weiterhin haben die Materialien auch ausgezeichnete Barriereeigenschaften gegenüber Wasser und Sauerstoff. Teilweise werden die vorgenannten Materialien bereits als Lebensmittelfolien eingesetzt. Es war überraschend, dass mit Hilfe dieser Materialien Injektionsschichten für Elektronenlöcher bereitgestellt werden können, welche sowohl eine besonders energieeffiziente Funktion des Bauelementes als auch eine besonders lange Lebensdauer gewährleisten.

In einer bevorzugten Ausführungsform der Erfindung ist das optoelektronische Bauelement dadurch gekennzeichnet, dass die mindestens eine Elektronentransportschicht eine Gesamtschichtdicke von 10 - 50 nm aufweist, welche besonders robust und zuverlässig ist. Dabei ist bevorzugt, dass sie eine Gesamtschichtdicke von 25 - 30 nm aufweist. Diese hat sich als besonders wartungsfrei und leicht herstellbar herausgestellt, wodurch Kosten gesenkt werden. Die mindestens eine Lochtransportschicht umfasst eine Gesamtschichtdicke von 10 - 40 nm, welche ebenfalls besonders robust und zuverlässig ist. Dabei ist eine Gesamtschichtdicke von 10 - 30 nm bevorzugt. Diese hat sich ebenfalls als besonders wartungsfrei und leicht herstellbar herausgestellt und senkt daher die Kosten. Es ist besonders bevorzugt, dass die Gesamtschichtdicke der Lochtransportschicht eine Dicke von 15 - 25 nm aufweist. Dadurch wird eine Verbesserung der elektrischen Eigenschaften erreicht. Die Gesamtschichtdicke bezeichnet bevorzugt die Dicke aller Elektronen- bzw. Lochtransportschichten. Im Falle der Verwendung jeweils einer Elektronen- bzw. Lochtransportschicht entspricht die Dicke der Dicke der Elektronen- bzw. Lochtransportschicht. Im Sinne der Erfindung bezeichnet die Dicke bevorzugt die Ausdehnung einer Schicht entlang des Schichtaufbaus zwischen den Elektroden und entlang des Ladungsträgertransports. Die vorgenannten Parameter sind vorteilhafterweise darauf optimiert, einerseits einen effektiven Schutz der optisch aktiven Schicht, insbesondere vor Sauerstoff und Wasser, und andererseits einen besonders dünnen Gesamtaufbau des optoelektronischen Bauelementes umzusetzen. Hierdurch kann ein besonders langlebiges und dennoch dünnes, biegsames Bauelement bereitgestellt werden. Des Weiteren wird die Zuverlässigkeit erhöht, und es kann eine besondere ästhetische Wirkung aufgrund der dünnen, nicht sichtbaren Schichten erzielt werden. Diese tragen synergistisch zur ästhetischen Wirkung bei einem emittierenden Bauelement auch dadurch bei, dass die Lichttransmission der Schichten erhöht und deren Streuung vermindert wird.

In einer weiteren bevorzugten Ausführungsform ist das optoelektronische Bauelement dadurch gekennzeichnet, dass die mindestens eine Elektroneninjektionsschicht eine Gesamtschichtdicke zwischen 0,1 nm und 10 nm aufweist. Eine solche Schichtdicke lässt sich besonders zuverlässig verarbeiten und trägt zur Verbesserung der elektrischen und optischen Eigenschaften bei. Besonders bevorzugt ist eine Schichtdicke zwischen 5 nm und 7 nm, da hier ein idealer Kompromiss zwischen gewünschten optischen und elektrischen Eigenschaften einerseits und einer Qualitätshebung des Herstellungsverfahrens andererseits vorliegt. Für die mindestens eine Lochinjektionsschicht ist eine Gesamtschichtdicke zwischen 0,1 nm und 10 nm bevorzugt. Die vorgenannt für die Elektroneninjektionsschicht geltenden Vorteile treffen hier analog zu. Dies gilt ebenso für die besonders bevorzugte Schichtdicke zwischen 5 nm und 7 nm. Die Gesamtschichtdicke quantifiziert bevorzugt die gesamte Ausdehnung jeweils aller Elektroneninjektionsschichten bzw. jeweils aller Lochinjektionsschichten. Im Falle einer Schicht ist die Gesamtschichtdicke bevorzugt gleich der Dicke der Schicht, andernfalls gleich der Summe der Dicke der einzelnen Schichten. Es wurde von den Erfindern erkannt, dass die vorgenannten Schichtdicken überraschenderweise sowohl ausgezeichnete Blockadeeigenschaften gegenüber Wasser und Sauerstoff erlauben, als auch eine effektives "Tunneln", wodurch die elektrische Funktion erfüllt wird.

Bei dieser besonders bevorzugten OLED kann vorteilhafterweise auf die Verwendung von Barrierefolien zur Verkapselung der OLED verzichtet werden. Hierdurch kann die OLED besonders dünnschichtig und mit einer Dicke von bevorzugt weniger als 300 nm konstruiert werden, wodurch das elektronischen Bauteil besonders dünn und flexibel gestaltet werden kann.

In einer weiteren bevorzugten Ausführungsform ist das flächige elektronische Bauteil dadurch gekennzeichnet, dass die Energiequelle eine Batterie, eine organische Solarzelle und/oder einen Kondensator umfasst. Die Aufnahme einer Batterie erlaubt eine autarke Versorgung der Anzeigenvorrichtung mit Strom. Batterien sind zudem kostengünstig erhältlich. Bevorzugt können die Batterien aus Lithium-Polymeren, Zink-Mangan und/oder Aluminium-Mangan-Polymeren hergestellt, da diese besonders flache Dimensionierungen erlauben. Es kann aber auch bevorzugt sein anstelle einer Batterie eine organische Solarzelle zu verwenden. Hierdurch ist es vorteilhafterweise möglich, dass das flächige elektronische Bauteil durch das Umgebungslicht mit elektrischer Energie versorgt wird. Die organische Solarzelle kann dabei verwandt werden, um die Anzeigenvorrichtung unmittelbar zu versorgen oder aber die erzeugte Energie in einer aufladbaren Batterie oder einem Kondensator, bevorzugt einem Dünnschichtkondensator, zwischen zu speichern. Dies erlaubt die Nutzbarkeit des Bauteiles über besonders lange Zeiträume. Zudem ist durch die Kombination aus OLED, Kondensator und Solarzelle ein Blinken bzw. Dimmen der OLED ohne Zuhilfenahme von Transistoren zu erreichen. Hierbei lädt der Kondensator sich durch die Solarzelle auf. Mit steigender Kapazität steigt die verfügbare Spannung. Sobald die Spannung des Kondensators V(C) größer als die V(onbias-OLED), d.h. die On-Set Spannung der OLED, welches die Mindestspannung für die OLED bezeichnet, leuchtet die OLED auf. Anschließend leuchtet die OLED solange auf, bis die Energie des Kondensators aufgebraucht wird. Hierbei kann auf einfache Weise ein Dimmeffekt bereitgestellt werden.

Organische Solarzellen sind im Stand der Technik hinreichend bekannt. Die vorteilhaften Eigenschaften von organisch halbleitenden Materialien zur Lichterzeugung wie obig für die OLEDs beschrieben, lassen sich ebenso auf die Erzeugung von elektrischem Strom übertragen. So zeichnen sich organische Solarzellen oder hybride Solarzellen gleichfalls durch einen dünnen Schichtaufbau aus, welcher die Einsatzmöglichkeiten gegenüber klassischen anorganischen Solarzellen deutlich erhöht. Der Aufbau von organischen Solarzellen oder hybriden Solarzellen weist Ähnlichkeiten mit OLEDs oder hybriden LEDs auf. Die Verwendung von organischen Solarzellen im Bauteil erhöht bevorzugt nicht die Wahrnehmbarkeit der Elektronik und erhält so die besondere ästhetische Wirkung des Bauteiles.

Anstatt einer Emitterschicht liegen als photoaktive Schicht jedoch eine oder mehrere Absorberschichten vor. In der Absorberschicht werden aufgrund einfallender elektromagnetischer Strahlung Elektronen-Loch-Paare als freie Ladungsträger erzeugt. Die weiteren Schichten umfassen Elektronen- und Lochtransportschichten sowie Elektronenextraktions- und Lochextraktionsschichten. Diese bestehen aus organischen Materialien oder im Falle von hybriden aus organischen und anorganischen Materialien, deren elektrochemischen Potentiale derart als Donator- und Akzeptorschichten verschoben sind, dass diese in der Solarzelle ein internes Feld erzeugen, welches die freien Ladungsträger zu den Elektroden abführt. Durch den Einfall der elektromagnetischen Strahlung werden dadurch an der Kathode Elektronen und an der Anode Elektronenlöcher zur Erzeugung einer Spannung bzw. eines Stromes bereitgestellt.

Die organischen Solarzellen des Standes der Technik lassen sich bereits hervorragend in die Elektronik des Bauteiles integrieren, es kann aber auch bevorzugt sein, organische Solarzellen zu verwenden, bei denen analog zu der besonders bevorzugten OLED die elektrisch aktiven Schichten, d.h. die Elektronen- und Lochtransportschichten sowie Elektronenextraktions- und Lochextraktionsschichten Blockadeeigenschaften gegenüber Wasser- und Sauerstoffmolekülen aufweisen. Die bevorzugt genannten Parameter für die Blockadeeigenschaften gelten analog, wobei auch ähnliche Materialien bevorzugt sein können. Der Fachmann weiß jedoch, dass die elektrischen Eigenschaften der elektrisch aktiven Schichten einer organischen Solarzelle im Vergleich zu einer OLED anzupassen sind. Eine solche bevorzugte organische Solarzelle ist wiederum durch eine besonders lange Lebensdauer, bei gleichzeitig (im Vergleich zu verkapselten Solarzellen) geringer Dicke ausgezeichnet.

In einer weiteren bevorzugten Ausführungsform ist das flächige elektronische Bauteil dadurch gekennzeichnet, dass die Leiterbahnen Silber, Kupfer und/oder Kohlenstoff als Druckmaterial umfassen. Diese Materialien zeichnen sich durch eine hohe Leitfähigkeit bei bereits geringen Dimensionierungen aus und sind somit optimal zur Bereitstellung der gedruckten Elektronik geeignet.

In einer bevorzugten Ausführungsform der Erfindung ist das flächige elektronische Bauteil dadurch gekennzeichnet, dass die Deckschicht mindestens teilweise transluzent ist. Hierdurch kann sichergestellt werden, dass die Anzeigenvorrichtung, bevorzugt die OLED, sichtbar ist. Bevorzugt ist die Deckschicht zwar transluzent, d.h. lichtdurchlässig, jedoch nicht transparent, d.h. bevorzugt blickdurchlässig, sodass das Licht der OLED an der Deckschicht gestreut wird. Hierdurch kann eine Projektion der optischen Abbildung der OLED auf die Deckschicht erreicht werden, wodurch deren Inhalte besonders real erscheinen. Weiterhin kann hierdurch eine besondere unauffällige Integration der Anzeigenvorrichtung in das Bauteil umgesetzt werden. Diese Ausführungsform führt zu einer besonderen ästhetischen Wirkung.

In einer bevorzugten Ausführungsform der Erfindung ist das flächige elektronische Bauteil dadurch gekennzeichnet, dass die Deckschicht zellulosehaltige Materialien umfasst. Diese sind kostengünstig verfügbar und leicht zu verarbeiten. Dabei umfasst die Deckschicht bevorzugt Papier und/oder Pappe. Diese sind robust und billig. Besonders bevorzugt umfasst die Deckschicht Transparentpapier, Brotpapier und/oder Folien aus bevorzugt Polyethylennaphthalat (PEN) und/oder Polyethylenterephthalat (PET). Diese erfüllen besonders gut die vorgenannten Anforderungen an die optischen Eigenschaften des Deckmaterials. Außerdem eignen sich diese Materialien hervorragend zum Abdecken der Elektronik. Sie stellen sowohl einen ausreichenden Schutz dar und sind darüber hinaus ausgezeichnet bedruckbar, sodass die optische Erscheinung des Bauteils besonders gut gestaltet werden kann.

Insbesondere lassen sich durch eine Bedruckung der Materialien elektronische Komponenten wie z. B. Batterien oder Leiterbahnen wirksam abdecken, während z.B. die OLED sichtbar bleibt. Bevorzugt erfolgt das Bedrucken der Deckschicht mittels Inkjet, Digitaldruck und/oder Offset. Diese Verfahren sind besonders einfach und kostengünstig umsetzbar. Durch entsprechende Lasierungen können mehrere Farben dargestellt werden. Außerdem weisen die genannten Materialien vorteilhafte transluzente Eigenschaften auf, so dass die Projektion der Lichtsignale der Anzeigenvorrichtung auf die Deckschicht ein besonders eindrucksvolles Abbild vermittelt, welches nicht von der Anzeigenvorrichtung, sondern direkt von der Deckschicht zu kommen scheint.

In einer weiteren bevorzugten Ausführungsform ist das flächige elektronische Bauteil dadurch gekennzeichnet, dass das nichtleitende Substrat Papier und/oder PET umfasst. Insbesondere mit diesen Materialien ist eine besonderes stabile und einfache Integration des Bauteiles in ein Produkt möglich. Zum einen sind die Materialien hinreichend biegsam und dünn. Zum anderen lassen sich die Materialien besonders schnell und leicht auf eine Fläche eines Produktes kleben. Das nichtleitende Substrat kann aber auch Aluminiumfolie und/oder Stahlbleche umfassen, welche durch eine Beschichtung eine nichtleitende Abschirmung gegenüber der Elektronik erhalten. Bevorzugte Dicken der Substrate sind zwischen 10 - 75µm

In einer weiteren bevorzugten Ausführungsform der Erfindung ist das flächige elektronische Bauteil dadurch gekennzeichnet, dass zwischen der Deckschicht und der Elektronik eine zusätzliche, nichtleitende Abdeckschicht vorliegt, welche eine Aussparung für die Anzeigenvorrichtung aufweist. Diese kann beispielsweise mit Hilfe von Siebdruck aufgebracht werden. Die nichtleitende Abdeckschicht dient insbesondere als zusätzliche optische Abdeckung, um Komponenten der Elektronik zu verdecken, welche nicht sichtbar sein sollen, wie z.B. Leiterbahnen oder Batterien. Durch die bevorzugte Aussparung kann jedoch die Anzeigenvorrichtung ungehindert leuchten. Es kann aber auch bevorzugt sein, dass die Abdeckschicht als optische Barriere dient, um Teile der OLED abzudecken. Anstatt die Abdeckschicht zwischen die Deckschicht und die Elektronik zu integrieren, kann diese auch direkt auf die Deckschicht mittels deckende Farben, z.B. Deckweiß gedruckt werden. Dieses kann auf beiden Seiten erfolgen. Erfolgt dies auf der Seite, wo das spätere Druckbild aufgetragen wird, so wird erst die Deckschicht und dann das Druckbild gedruckt. Dieses ermöglicht zudem das Aufbringen, bevorzugt den Druck, der Elektronik direkt auf der Rückseite der Deckschicht. Wird hingegen die Abdeckschicht auf der Rückseite der Deckschicht gedruckt appliziert, dann kann im Anschluss daran die Elektronik auf die Deckschicht gedruckt werden. In dieser Ausführungsform wird somit die Elektronik bevorzugt auf die Deckschicht und nicht auf separates Substrat aufgebracht bzw. fungiert die Deckschicht als ein Substrat. Auf diese Weise können vorteilhafterweise 1-2 Schichten eingespart werden. Die Abdeckschicht dient bevorzugt als Ausgleichsschicht, welche eine unterschiedliche Höhe von Komponenten der elektronischen Schicht ausgleichen kann. Somit kann eine haptische und optische nahtlose Integration der Elektronik erzielt werden. Darüber hinaus kann die Abdeckschicht als zusätzlicher Schutz der Elektronik fungieren und die Robustheit des Bauteils erhöhen.

In einer weiteren bevorzugten Ausführungsform ist das flächige elektronische Bauteil dadurch gekennzeichnet, dass die Elektronik einen Schalter umfasst zur Aktivierung der Anzeigenvorrichtung. Damit die Anzeigenvorrichtung angeschaltet werden kann, kann bevorzugt ein Kontaktschalter integriert werden, der manuell betätigt wird. Dieser Schalter kann durch Integration einer separaten Komponente, welche z.B. ein bekannter Druckschalter ist, und auf den Druck durch einen Finger einen Schaltkreis schließen, wodurch die Energiequelle an die Anzeigenvorrichtung angeschlossen wird und diese leuchtet. Somit kann die Anzeigenvorrichtung Ein- und ausgeschaltet werden, je nach Bedarf. Das erhöht die Energieeffizienz und die Lebensdauer.

In einer weiteren bevorzugten Ausführungsform ist das flächige elektronische Bauteil dadurch gekennzeichnet, dass die Deckschicht und/oder die nichtleitende Abdeckschicht eine Aussparung oberhalb einer Leiterbahn umfasst, wobei durch deren Berührung mit einem leitfähigen Objekt ein Stromkreis geschlossen wird, sodass die Anzeigenvorrichtung leuchtet. Es ist besonders bevorzugt, dass die Deckschicht keine Aussparung, sondern lediglich die nichtleitende Abdeckschicht eine Aussparung aufweist. Durch Berührung der Aussparung und somit der darunterliegenden Leiterbahn kann somit wie bei dem vorgenannten Kontaktschalter auf einfache Weise ein Stromkreis geschlossen werden. Bei entsprechender Konfiguration der Leiterbahnen kann hierdurch die Anzeigenvorrichtung nur dann leuchten, wenn die Aussparung kontaktiert wird. Durch derartige Schalter ist eine interaktive und somit besonders ansprechende Nutzung des Bauteiles möglich. Es wird eine besondere ästhetische Wirkung erzielt.

In einer weiteren bevorzugten Ausführungsform ist das flächige elektronische Bauteil dadurch gekennzeichnet, dass die Elektronik einen Sensor, bevorzugt einen Lichtsensor umfasst. Im Bereich der Verpackung oder Printwerbung kann es wünschenswert sein, dass das Bauteil nur dann leuchtet, wenn es zum Beispiel vorne im Supermarkt im Regal steht bzw. wenn der Nutzer die Seite mit der integrierten Printwerbung herausnimmt und ansieht. Dies wird dadurch erreicht, dass ein lichtsensitiver Sensor in das Bauteil integriert wird. Da die Deckschicht bevorzugt transluzent ist erhält der Sensor ausreichend Energie und schaltet den Stromkreis erst ab einem definierten Lichteinfall ein. Durch diese bevorzugte Ausführungsform können Energiekosten gespart werden.

In einer weiteren bevorzugten Ausführungsform ist das flächige elektronische Bauteil dadurch gekennzeichnet, dass die Elektronik eine Steuerungselektronik mit einem oder mehreren Transistoren umfasst. Hierdurch können auch komplexere Steuerungen der Anzeigenvorrichtung mit zeitlichen und/oder räumlichen Mustern erfolgen. Gegebenenfalls kann die Steuerelektronik auch eine Kommunikationseinheit zur Kommunikation mit externen Geräten umfassen. Die Kommunikation kann beispielsweise mit Hilfe von Antennen, RFID, NFC, Blue Tooth Low Energy oder Lichtfrequenzübertragung erfolgen. Hierdurch kann das Bauteil auch extern aktiviert und/oder reguliert werden, wodurch ein verbessertes Einbindungspotential für die Verbraucher erhalten wird. Beispielsweise können diese ihre Smartphones nutzen, um ggf. mit Hilfe von Bluetooth das elektronische Bauteil zum Leuchten zu bringen oder das Bauteil kann vom Smartphone Daten empfangen und dementsprechend personalisierte Inhalte darstellen.

In einer weiteren bevorzugten Ausführungsform betrifft die Erfindung ein Verfahren zur Herstellung eines erfindungsgemäßen flächigen elektronischen Bauteiles oder bevorzugten Ausführungsformen davon umfassend folgende Schritte
- Bereitstellung des nichtleitenden Substrats,
- Aufbringen der Elektronik auf das Substrat umfassend die Anzeigenvorrichtung, die Energiequelle und die Leiterbahn
- Aufbringen der bedruckbaren Deckschicht auf die Elektronik. So kann ein besonders robustes und wartungsfreies Bauteil bereitgestellt werden.

In einer weiteren bevorzugten Ausführungsform betrifft die Erfindung ein Verfahren zur Herstellung eines erfindungsgemäßen flächigen elektronischen Bauteiles oder bevorzugten Ausführungsformen davon umfassend folgende Schritte
- Bereitstellung einer Deckschicht
- Aufbringung einer Abdeckschicht auf Vor- und/oder Rückseite der Deckschicht
- Aufbringen der Elektronik auf die Rückseite der Deckschicht bzw. der Abdeckschicht. Ein solches Bauteil ist sehr zuverlässig man kann es besonders einfach herstellen.

In dieser Ausführungsform wird somit die Elektronik bevorzugt auf die Deckschicht und nicht auf ein separates Substrat aufgebracht, d.h. die Deckschicht mit der Abdeckschicht fungiert als ein Substrat. Auf diese Weise können vorteilhafterweise Schichten eingespart werden.

Der Fachmann erkennt, dass die bevorzugten Ausführungsformen und Vorteile dieser, welche für das flächige elektronische Bauteil offenbart wurden, ebenfalls für das erfindungsgemäße Verfahren gelten. So wurde zum Beispiel offenbart, dass es für das Bauteil bevorzugt ist, dass die Leiterbahnen mit Hilfe eines Druckverfahrens ausgewählt aus Gruppe umfassend Inkjet, Siebdruck, Flexodruck, Offset-Druck aufgebracht werden, wobei bevorzugt Silber, Kupfer und/oder Kohlenstoff zum Einsatz kommen. Der Fachmann erkennt somit, dass auch für das erfindungsgemäße Verfahren die Ausführungsform bevorzugt ist in welche das Aufbringen der Elektronik solche Druckverfahren zum Aufbringen der Leiterbahnen umfasst. Ein solches Verfahren kann darüber hinaus besonders gut rationalisiert und automatisiert werden.

In einer weiteren bevorzugten Ausführungsform betrifft die Erfindung eine Verwendung des erfindungsgemäßen flächigen elektronischen Bauteiles oder bevorzugten Ausführungsformen davon für die Gestaltung von Produkten und Verpackungen, insbesondere Print- und Papierprodukten, wobei das flächige elektronische Bauteil auf eine Fläche der Produkte oder Verpackungen mit Hilfe eines Klebers aufgebracht wird. Eine solche Verwendung kann eine besondere ästhetische Wirkung im Zusammenwirkung mit dem Produkt zur Folge haben.

In einer weiteren bevorzugten Ausführungsform betrifft die Erfindung ein Produkt, welches dadurch gekennzeichnet, dass das erfindungsgemäße flächige elektronische Bauteil oder bevorzugten Ausführungsformen davon an einer Fläche des Produktes angebracht vorliegt. Die Anbringung ist bevorzugt durch ein Kleben des Substrates auf die Produktfläche erfolgt. Diese Ausführungsform ist besonders robust.

In einer weiteren bevorzugten Ausführungsform betrifft die Erfindung ein Produkt, wobei das Produkt eine Fläche aus einem mindestens teilweise transluzenten Material umfasst, welches auf einer Seite einen Aufdruck aufweist, wobei eine Elektronik umfassend eine Anzeigenvorrichtung, eine Energiequelle und eine Leiterbahn auf die gegenüberliegende Seite des Aufdruckes aufgebracht vorliegt, sodass das Leuchtsignal der Anzeigenvorrichtung durch die Fläche hindurch sichtbar ist. Hierdurch kann eine besondere optische Wirkung erzielt werden.

Es kann somit auch bevorzugt sein, Flächen des Produktes als nichtleitendes Substrat oder transluzente Deckschicht zu nutzen, auf welche die Elektronik aufgebracht wird. Hierzu ist es bevorzugt, dass die Produktfläche eine entsprechende Transluszenz, d.h. eine zumindest teilweise Lichtdurchlässigkeit, aufweist. Die Lichtausbeute kann durch das Verdrucken bestimmter Lösungsmittel- und/oder Materialkombinationen auf eine nicht und oder semi-transparente bzw. opaque Schicht verbessert werden. Die Umsetzung dieser Ausführungsform ist besonders einfach.

In einer weiteren bevorzugten Ausführungsform betrifft die Erfindung zudem das Produkt, wobei die Fläche ein Karton und/oder ein Papier ist, wobei die Fläche mit Hilfe einer Klebung auf eine Wellpappe aufgebracht wird. In diesem Produkt wird somit die erfindungsgemäße Integration der Elektronik in ein Produkt vorteilhafterweise durch bekannte Kaschierprozesse vermittelt. Diese werden insbesondere zur Herstellung von Verpackungen genutzt. Dabei wird auf eine Wellpappe ein bedruckter Karton appliziert mittels einer Klebung. In der bevorzugten Ausführungsform wird auf die nichtbedruckte Seite ebendieses Kartons die Elektronik gedruckt bzw. aufgebracht. Wenn dieser Karton hinreichend transluzent ist, kann vorteilhafterweise die beschriebene Projektion des Abbildes der Anzeigenvorrichtung auf die Vorderseite des Kartons projiziert werden, welche somit eine transluzente Deckschicht darstellt. Ein solches Produkt kann auf besonders einfache Weise eine besondere ästhetische Wirkung erzielen.

### Detaillierte Beschreibung der Erfindung

Im Folgenden soll die Erfindung anhand von Beispielen näher erläutert werden, ohne auf diese beschränkt zu sein.

### Kurzbeschreibung der Figuren

- Fig. 1a, b: Schematische Darstellung der Integration von Elektronik in bestehende Produkte im Stand der Technik
- Fig. 2a-c: Schematische Darstellung einer bevorzugten Ausführungsform des erfindungsgemäßen flächigen Bauteiles und Illustration von dessen Integration in ein Produkt
- Fig. 3a, b: Schematische Darstellung einer bevorzugten Ausführungsform des erfindungsgemäßen flächigen Bauteiles zur Illustration bevorzugter Deckschichten

### Detaillierte Beschreibung der Figuren

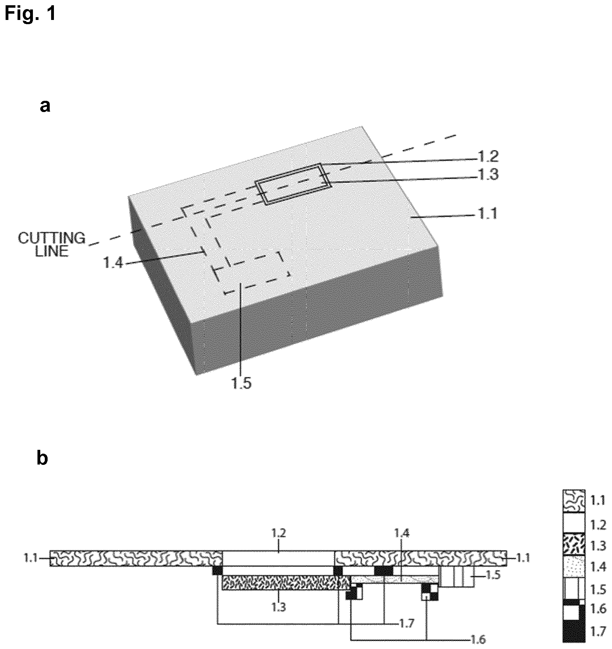

Fig. 1 a und b ist eine schematische Darstellung zur Integration von Elektronik in bestehende Produkte, wie sie im Stand der Technik bekannt ist. Das Produkt umfasst eine Fläche 1.1, an welcher die Elektronik appliziert werden soll. Fig. 1a zeigt eine dreidimensionale Ansicht des Produktes und Fig. 1b zeigt einen Schnitt durch die Fläche 1.1. Diese Fläche 1.1 kann beispielsweise die Papier- oder Kartonfläche einer Verpackung sein. In die Fläche 1.1. soll eine Elektronik umfassend eine Anzeigenvorrichtung 1.3, wie beispielsweise eine Leuchtdiode (LED), integriert werden. Zu diesem Zweck ist es im Stand der Technik notwendig die Fläche 1.1. des Produktes aufzutrennen. In Fig. 1a wird dies schematisch durch die gestrichelte Linie (cut) illustriert. Anschließend werden die elektronischen Komponenten wie die Anzeigenvorrichtung 1.3, die Batterie 1.5 sowie Kabel 1.4 zur Verbindung der Batterie 1.5 mit der Anzeigenvorrichtung 1.3 hinter die durch den Schnitt geöffnete Fläche 1.1 gebracht. Übliche Papier- und Kartonflächen der Verpackung von Produkten sind nicht transparent oder nicht ausreichend transparent, um das Leuchtsignal der Anzeigenvorrichtung sichtbar werden zu lassen. Aus diesem Grund ist es notwendig, dass an der Position der Anzeigenvorrichtung 1.3 eine Aussparung oder Öffnung 1.2 in der Fläche 1.1 bereitgestellt wird. Die Öffnung 1.2 stellt somit eine Inhomogenität dar, welche für den Verbraucher sichtbar werden lässt, dass eine Elektronik integriert worden ist. Fig. 1b zeigt einen Schnitt durch die in die Fläche 1.1 eingebrachte Elektronik entlang der in Fig. 1a gezeigten gestrichelten Linie. Neben dem Stanzen und Schneiden zum Einbringen ist es notwendig, die elektrischen Komponenten wie die Batterie 1.5 und die Kabel 1.4 auf der gegenüberliegenden Seite der Fläche 1.1 zu verbinden. Im Stand der Technik wird daher die Elektronik oftmals vorab zusammengefügt unter Zuhilfenahme aufwändiger Lötprozesse. Anschließend wird die Elektronik hinter die Fläche 1.1. zum Beispiel mit einem Bestücker gebracht, wobei Klebstoffe 1.7 und/oder Lötzinn 1.6 notwendig sind, um die Elektronik an der inneren Seite der Fläche 1.1. zu befestigen.

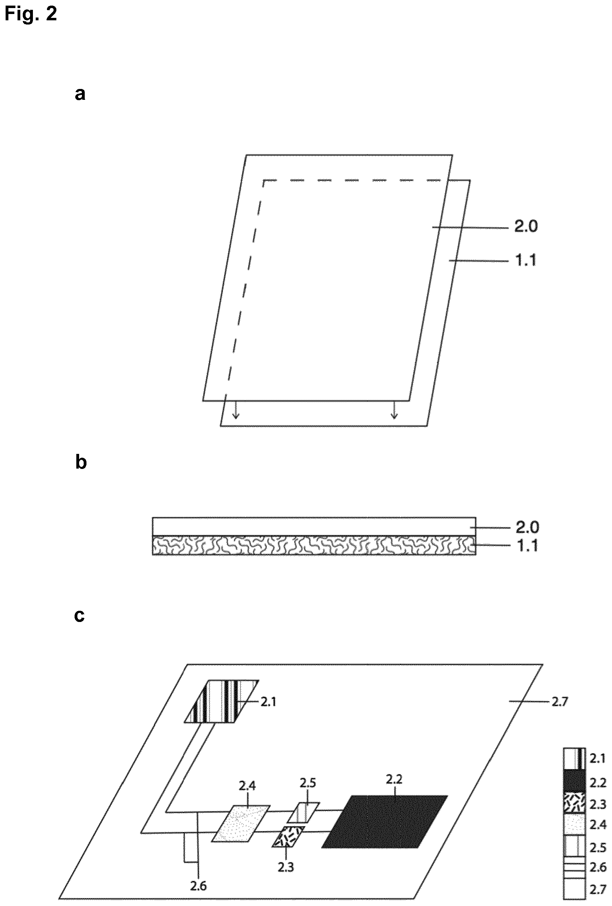

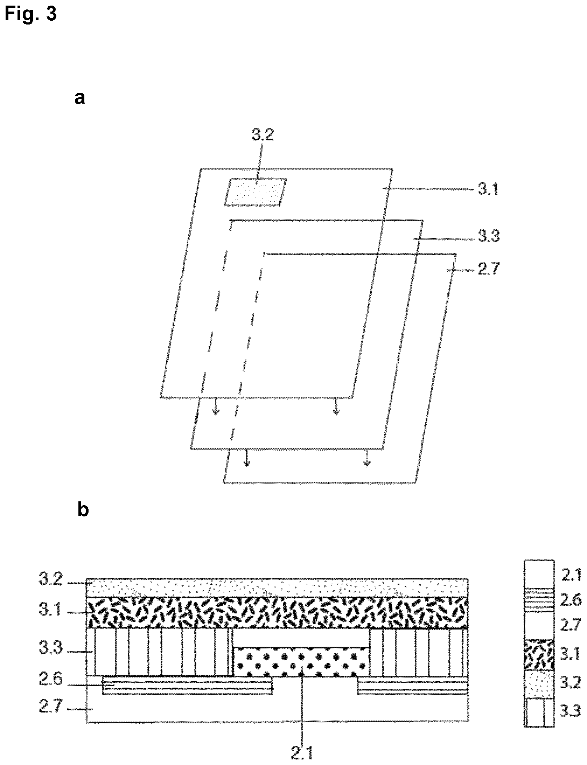

Fig. 2 zeigt eine bevorzugte Ausführungsform des erfindungsgemäßen flächigen Bauteiles 2.0 und dessen Integration in die Fläche 1.1. eines Produktes. Mit Hilfe des erfindungsgemäßen flächigen Bauteiles 2.0 ist es nicht notwendig, die Fläche 1.1. des Produktes zur Integration der Elektronik aufzutrennen. Vielmehr kann das erfindungsgemäße flächige Bauteil 2.0, in welches bereits die Elektronik integriert ist, durch einen einfachen Kleber auf die Fläche 1.1 des Produktes aufgebracht werden (Fig. 2a). Es ist besonders bevorzugt, dass die Dimension des flächigen Bauteiles 2.0 an die Größe der Fläche 1.1 angepasst ist, so dass keine Ränder sichtbar sind. Hierdurch ist für einen Kunden im Gegensatz zu bekannten destruktiven Methoden, die Integration des flächigen Bauteiles 2.0 auf der Produktfläche 1.1. nicht sichtbar. Das flächige Bauteil 2.0 ist bevorzugt weniger als 0,3 mm dick und kann als ein Laminat aus mindestens zwei, bevorzugt mindestens drei Schichten betrachtet werden. Fig. 2b zeigt einen Schnitt durch die Produktfläche 1.1 und das flächige Bauteil 2.0. Fig. 2c illustriert die in dem flächigen Bauteil 2.0 integrierte Elektronik. Als untere Lage weist das flächige Bauteil 2.0 ein nichtleitendes Substrat 2.7 auf. Auf das Substrat 2.7 wird eine OLED-Anzeigevorrichtung 2.1, und eine Energiequelle 2.2., z.B. eine Batterie aufgebracht. Weiterhin können weitere elektronische Komponenten auf das Substrat 2.7 aufgebracht werden. Bevorzugt erfolgt dies zumindest teilweise mit Hilfe eines Druckverfahrens. In der gezeigten bevorzugten Ausführungsform liegen auf dem Substrat 2.7 Leiterbahnen 2.6 vor, welche die Anzeigenvorrichtung 2.1 mit einer Steuerelektronik 2.4 verbinden, welche z.B. eine Empfangseinheit aufweisen kann, zur Ansteuerung der Anzeigenvorrichtung 2.1 mit Hilfe externer Geräte (nicht gezeigt). In der dargestellten Ausführungsform ist die Steuerelektronik an einen Sensor 2.3 und/oder einen Schalter 2.5 angeschlossen. Der Sensor 2.3 kann z.B. ein lichtsensitiver Sensor sein, welcher eine Spannung von der Energiequelle 2.2., z.B. eine Batterie, an die Anzeigenvorrichtung 2.1 freischaltet. Auch kann es zu diesem Zweck bevorzugt sein, dass der Schalter 2.5 beispielsweise durch ein Drücken die Freigabe von elektrischem Strom von der Energiequelle 2.2 an die Anzeigenvorrichtung 2.1 bewirkt. Der Schalter 2.5 und der Sensor 2.3 können sowohl alternativ zueinander oder in Kombination die Verbindung der Anzeigenvorrichtung 2.1 mit der Energiequelle 2.2 regulieren. Es ist bevorzugt, dass die mittlere Lage umfassend die Elektronik durch eine bedruckbare Deckschicht 3.1 abgedeckt wird. Die Funktionsweise einer bevorzugten Ausführungsform der oberen Lage der bedruckbaren Deckschicht 3.1 wird in Fig. 3 gezeigt.

Fig. 3 zeigt eine schematische Darstellung einer bevorzugten Ausführungsform des erfindungsgemäßen flächigen Bauteiles zur Illustration bevorzugter Deckschichten. Auf dem Substrat 2.7 ist wie in Fig. 2 gezeigt eine Elektronik aufgebracht. Zur leichteren Übersicht wird diese nicht in Fig. 3a gezeigt. In der dargestellten Ausführungsform wird auf die Elektronik zunächst eine nichtleitende Abdeckschicht 3.3, beispielsweise mit Hilfe von Siebdruck, aufgebracht. Diese dient insbesondere als zusätzliche optische Abdeckung, um die Komponenten der Elektronik zu verdecken. Auf der nichtleitenden Abdeckschicht 3.3 wird in der bevorzugten Ausführungsform eine bedruckbare Deckschicht 3.1 aufgebracht. Es kann auch bevorzugt sein, die Deckschicht 3.1 direkt auf das Substrat aufzubringen. Die Deckschicht ist bevorzugt mindestens teilweise transluzent, sodass die Anzeigenvorrichtung 2.1 durch die Deckschicht 3.1 durchscheinen kann. Es ist bevorzugt, dass ein farblicher Aufdruck 3.2, zum Beispiel mit Hilfe von verschiedenen Lasierungen auf die bedruckbare Deckschicht 3.1, aufgebracht wird. Bevorzugt werden die Farben des Aufdruckes derart gewählt, dass zumindest das gewünschte Leuchtsignal der Anzeigenvorrichtung 2.1 sichtbar bleibt, während andere Elektronikkomponenten wie die Leiterbahnen 2.6 abgedeckt werden. Die Fig. 3b zeigte eine Schnittdarstellung eines Ausschnittes des flächigen elektronischen Bauteiles von Fig. 3a. Die Anzeigenvorrichtung 2.1 ist mit Leiterbahnen 2.6 an eine Energiequelle (nicht gezeigt) verbunden. Auf die Leiterbahnen 2.6, jedoch nicht auf die Anzeigenvorrichtung 2.1, wurde eine nichtleitende Abdeckschicht 3.3 mit Hilfe eines Druckverfahrens, bevorzugt Siebdruck, gebracht, welche optisch blickdicht ist und somit die Leiterbahnen 2.6 verdeckt. Über der Anzeigenvorrichtung 2.1, wie auch über der Abdeckschicht 3.3 wird eine bedruckbare Deckschicht 3.1 gebracht, welche mindestens teilweise transluzent ist. Die Deckschicht 3.1 kann durch Aufbringen eines Aufdruckes 3.2, bevorzugt eine Farbschicht, optisch so gestaltet werden, wie es für das Produkt gewünscht ist. Bevorzugt wird die Druckerfarbe zum Bedrucken der Deckschicht 3.1 derart gewählt, dass das Leuchtsignal der Anzeigenvorrichtung 2.1 durch die Deckschicht 3.1 und den Aufdruck 3.2 durchscheinen kann. Hierdurch wird eine homogene Gestaltungsfläche erhalten, wobei die Anzeigenvorrichtung 2.1 optisch in die Produktfläche 1.1 integriert ist, ohne dass für den Kunden ersichtlich wird, dass das Produkt eine Elektronik enthält.

### Bezugszeichenliste

- 1.1: Seitenfläche eines Produktes
- 1.2: Öffnung für Anzeigenvorrichtung
- 1.3: Anzeigenvorrichtung
- 1.4: Kabel
- 1.5: Batterie
- 1.6: Lötzinn
- 1.7: Klebstoff
- 2.0: flächiges elektronisches Bauteil
- 2.1: OLED-Anzeigevorrichtung
- 2.2: Energiequelle
- 2.3: Sensor
- 2.4: Steuerungselektronik
- 2.5: Schalter
- 2.6: Leiterbahnen
- 2.7: nichtleitendes Substrat
- 3.1: bedruckbare Deckschicht
- 3.2: Aufdruck
- 3.3: nichtleitende Abdeckschicht

## Patentansprüche

1. Flächiges elektronisches Bauteil (2.0) umfassend eine Anzeigenvorrichtung zur Erzeugung
eines Leuchtsignales, eine Energiequelle und eine Leiterbahn
wobei
das Bauteil eine untere Lage (2.7) eines nichtleitenden Substrats,
eine mittlere Lage einer Elektronik, umfassend die Anzeigevorrichtung (2.1), die Energiequelle (2.2) und die Leiterbahn (2.6), wobei die Anzeigenvorrichtung eine OLED-Anzeigevorrichtung (2.1) ist und die Elektronik mindestens teilweise, bevorzugt vollständig, mit einem Druckverfahren auf das Substrat aufgebracht wurde und eine obere Lage einer bedruckbaren Deckschicht (3.1) umfasst, wobei die Deckschicht mindestens teilweise transluzent ist, sodass das Leuchtsignal der Anzeigenvorrichtung an der Deckschicht gestreut wird und die Deckschicht als eine Projektionsfläche für das Leuchtsignal fungiert und wobei das flächige elektronische Bauteil eine Dicke von weniger als 1 mm aufweist.

2. Flächiges elektronisches Bauteil (2.0) umfassend eine Anzeigenvorrichtung zur Erzeugung
eines Leuchtsignales, eine Energiequelle und eine Leiterbahn
wobei
eine Lage einer Elektronik, umfassend die Anzeigevorrichtung (2.1), Energiequelle (2.2) und die Leiterbahn (2.6) auf einer oberen Lage einer bedruckbaren Deckschicht (3.1) aufgebracht ist, welche ein nichtleitendes Substrat ist, wobei die Anzeigenvorrichtung
eine OLED-Anzeigevorrichtung ist und die Elektronik mindestens teilweise, bevorzugt vollständig, mit einem Druckverfahren auf die Deckschicht aufgebracht wurde
und wobei die Deckschicht mindestens teilweise transluzent ist, sodass das Leuchtsignal der Anzeigenvorrichtung an der Deckschicht gestreut wird und die Deckschicht als eine Projektionsfläche für das Leuchtsignal fungiert und wobei das flächige elektronische Bauteil eine Dicke von weniger als 1 mm aufweist.

3. Flächiges elektronisches Bauteil (2.0) gemäß einem der vorherigen Ansprüche wobei das Bauteil eine Dicke von weniger als 0,3 mm aufweist.

4. Flächiges elektronisches Bauteil (3.0) gemäß einem der vorherigen Ansprüche wobei das Druckverfahren ausgewählt aus einer Gruppe umfassend Inkjet, Siebdruck, Flexodruck, Offset-Druck.

5. Flächiges elektronisches Bauteil (2.0) gemäß einem der vorherigen Ansprüche wobei
die OLED Anzeigevorrichtung (2.1) eine Kathode, eine Anode und ein Schichtsystem zwischen der Kathode
und der Anode aufweist, umfassend
- mindestens eine kathodennahe Elektroneninjektionsschicht,
- mindestens eine Elektronentransportschicht
- mindestens eine optisch aktive Schicht
- mindestens eine Lochtransportschicht
- mindestens eine anodennahe Lochinjektionsschicht
wobei die mindestens eine Elektroneninjektionsschicht und die mindestens eine Lochinjektionsschicht diffusionslimitierend gegenüber Wasser und/oder Sauerstoff sind und
die mindestens eine Elektronentransportschicht und die mindestens eine Lochtransportschicht eine Diffusionsbarriere gegenüber Wasser und/oder Sauerstoff darstellen.

6. Flächiges elektronisches Bauteil (2.0) gemäß einem der vorherigen Ansprüche
wobei
die Energiequelle (2.2) eine Batterie, eine organische Solarzelle und/oder einen Kondensator umfasst und/oder
die Leiterbahnen (2.6) Silber, Kupfer und/oder Kohlenstoff als Druckmaterial umfassen

7. Flächiges elektronisches Bauteil (2.0) gemäß einem der vorherigen Ansprüche
wobei
die Deckschicht (3.1) zellulosehaltige Materialien, bevorzugt Papier und/oder Pappe besonders bevorzugt Transparentpapier, Brotpapier und/oder Folien aus bevorzugt Polyethylennaphthalat (PEN) und/oder Polyethylenterephthalat (PET) umfasst und/oder
das nichtleitende Substrat (2.7) Papier und/oder PET umfasst

8. Flächiges elektronisches Bauteil (2.0) gemäß einem der vorherigen Ansprüche wobei zwischen der Deckschicht (3.1) und der Elektronik eine zusätzliche nichtleitende Abdeckschicht (3.3) vorliegt, welche eine Aussparung für die Anzeigenvorrichtung aufweist.

9. Flächiges elektronisches Bauteil (2.0) gemäß einem der vorherigen Ansprüche
wobei
die Elektronik einen Schalter (2.5) umfasst zur Aktivierung der Anzeigenvorrichtung
und/oder
die Deckschicht eine Aussparung oberhalb einer Leiterbahn umfasst, wobei durch deren Berührung mit einem leitfähigen Objekt ein Stromkreis geschlossen wird, sodass die Anzeigenvorrichtung leuchtet.

10. Flächiges elektronisches Bauteil (2.0) gemäß einem der vorherigen Ansprüche
wobei
die Elektronik einen Sensor (2.3), bevorzugt einen Lichtsensor umfasst und/oder
die Elektronik eine Steuerungselektronik mit einem oder mehreren Transistoren umfasst.

11. Verfahren zur Herstellung eines flächigen elektronischen Bauteiles (2.0) gemäß Anspruch 1, umfassend folgende Schritte
- Bereitstellung eines nichtleitenden Substrats (2.7)
- Aufbringen einer Elektronik umfassend eine Anzeigenvorrichtung (2.1) zur Erzeugung von Lichtsignalen, eine Energiequelle (2.2) und Leiterbahnen (2.6) auf das Substrat wobei die Anzeigenvorrichtung eine OLED-Anzeigevorrichtung (2.1) ist und die Elektronik mindestens teilweise, bevorzugt vollständig, mit einem Druckverfahren auf das Substrat aufgebracht wurde
- Aufbringen einer bedruckbaren Deckschicht (3.1) auf die Elektronik, wobei die Deckschicht mindestens teilweise transluzent ist, sodass das Leuchtsignal der Anzeigenvorrichtung an der Deckschicht gestreut wird und die Deckschicht als eine Projektionsfläche für das Leuchtsignal fungiert.

12. Verfahren zur Herstellung eines flächigen elektronischen Bauteiles (2.0) gemäß Anspruch 2 umfassend folgende Schritte
- Bereitstellung einer Deckschicht (3.1), welche ein nichtleitendes Substrat ist
- Aufbringen einer Abdeckschicht (3.3) auf Vor- und/oder Rückseite der Deckschicht
- Aufbringen einer Elektronik umfassend eine Anzeigenvorrichtung (2.1) zur
Erzeugung eines Leuchtsignales, die eine Energiequelle (2.2) und die Leiterbahnen (2.6) auf die
Rückseite der Deckschicht bzw. der Abdeckschicht, wobei die Anzeigenvorrichtung
eine OLED-Anzeigevorrichtung (2.1) e ist und die Elektronik mindestens teilweise, bevorzugt vollständig, mit einem Druckverfahren aufgebracht wurde und
wobei die Deckschicht (3.1) mindestens teilweise transluzent ist, sodass das Leuchtsignal
der Anzeigenvorrichtung an der Deckschicht gestreut wird und die Deckschicht als eine Projektionsfläche für das Leuchtsignal fungiert..

13. Verwendung eines flächigen elektronischen Bauteiles (2.0) gemäß einem der Ansprüche 1- 10 für die Gestaltung von Produkten und Verpackungen, insbesondere Print- und Papierprodukten, wobei das flächige elektronische Bauteil auf eine Fläche der Produkte oder Verpackungen mit Hilfe eines Klebers aufgebracht wird.

14. Produkt wobei ein flächiges elektronisches Bauteil gemäß einem der Ansprüche 1- 10 an einer Fläche des Produktes angebracht vorliegt.

15. Produkt
wobei
das Produkt eine Fläche (1.1) aus einem mindestens teilweise transluzenten Material umfasst, welches auf einer Seite einen Aufdruck aufweist,
wobei eine Elektronik umfassend eine Anzeigenvorrichtung (1.3) zur Erzeugung von Lichtsignalen, eine Energiequelle (1.5) und eine Leiterbahn (1.4) auf die gegenüberliegende Seite des Aufdruckes aufgebracht vorliegt, sodass die Fläche als ein nichtleitendes Substrat für die Elektronik dient, wobei die Anzeigenvorrichtung eine OLED-Anzeigevorrichtung ist und die Elektronik mindestens teilweise, bevorzugt vollständig, mit einem Druckverfahren auf die Fläche aufgebracht wurde, sodass die Fläche für die Elektronik eine transluzente Deckschicht darstellt und das Leuchtsignal der Anzeigenvorrichtung durch die Fläche hindurch sichtbar ist und gestreut wird, sodass die Fläche als eine Projektionsfläche für das Leuchtsignal fungiert.

## Claims

1. A sheetlike electronic component (2.0) comprising a display device for generating a light signal, an energy source, and a conductor track
wherein
the component comprises a lower layer (2.7) of a non-conductive substrate, a middle layer of electronics, comprising the display device (2.1), the energy source (2.2), and the conductor track (2.6), wherein the display device is an OLED display device (2.1) and the electronics were applied at least partially, preferably completely, to the substrate using a printing method, and an upper layer of a printable cover layer (3.1), wherein the cover layer is at least partially translucent, so that the light signal of the display device is scattered at the cover layer and the cover layer functions as a projection surface for the light signal, and wherein the sheetlike electronic component has a thickness of less than 1 mm.

2. A sheetlike electronic component (2.0) comprising a display device for generating a light signal, an energy source, and a conductor track
wherein
a layer of electronics comprising the display device (2.1), the energy source (2.2), and the conductor track (2.6) is applied to an upper layer of a printable cover layer (3.1), which is a non-conductive substrate, wherein the display device is an OLED display device and the electronics were at least partially, preferably completely, applied to the cover layer using a printing method,
wherein the cover layer is at least partially translucent, so that the light signal of the display device is scattered at the cover layer and the cover layer functions as a projection surface for the light signal, and wherein the sheetlike electronic component has a thickness of less than 1 mm.

3. The sheetlike electronic component (2.0) as claimed in any one of the preceding claims
wherein
the component has a thickness of less than 0.3 mm.

4. The sheetlike electronic component (3.0) as claimed in any one of the preceding claims
wherein
the printing method is selected from a group comprising inkjet, screen printing, flexographic printing, offset printing.

5. The sheetlike electronic component (2.0) as claimed in any one of the preceding claims
wherein
the OLED display device (2.1) includes a cathode, an anode, and a layer system between the cathode
and the anode, comprising
- at least one electron injection layer near the cathode,
- at least one electron transport layer
- at least one optically active layer
- at least one hole transport layer
- at least one hole injection layer near the anode,
wherein the at least one electron injection layer and the at least one hole injection layer are diffusion-limiting with respect to water and/or oxygen, and
the at least one electron transport layer and the at least one hole transport layer represent a diffusion barrier to water and/or oxygen.

6. The sheetlike electronic component (2.0) as claimed in any one of the preceding claims
wherein
the energy source (2.2) comprises a battery, an organic solar cell and/or a capacitor, and/or
the conductor tracks (2.6) comprise silver, copper and/or carbon as the printing material.

7. The sheetlike electronic component (2.0) as claimed in any one of the preceding claims
wherein
the cover layer (3.1) comprises cellulose-containing materials, preferably paper and/or cardboard, particularly preferably tracing paper, waxed paper, and/or films preferably made from polyethylene naphthalate (PEN) and/or polyethylene terephthalate (PET), and/or
the non-conductive substrate (2.7) comprises paper and/or PET.

8. The sheetlike electronic component (2.0) as claimed in any one of the preceding claims
wherein
between the cover layer (3.1) and the electronics there is an additional non-conductive cover layer (3.3) which has a recess for the display device.

9. The sheetlike electronic component (2.0) as claimed in any one of the preceding claims
wherein
the electronics comprise a switch (2.5) for activating the display device, and/or
the cover layer comprises a recess above a conductive track, wherein a circuit is closed by a contact with a conductive object, so that the display device is illuminated.

10. The sheetlike electronic component (2.0) as claimed in any one of the preceding claims
wherein
the electronics comprise a sensor (2.3), preferably a light sensor, and/or
the electronics comprise control electronics with one or more transistors.

11. A method for producing a sheetlike electronic component (2.0) as claimed in claim 1, comprising the following steps
- providing a non-conductive substrate (2.7)
- applying electronics comprising a display device (2.1) for generating light signals, an energy source (2.2), and conductor tracks (2.6) to the substrate,
wherein the display device is an OLED display device (2.1) and the electronics were applied at least partially, preferably completely, to the substrate using a printing process
- applying a printable cover layer (3.1) to the electronics, wherein the cover layer is at least partially translucent, so that the light signal of the display device is scattered at the cover layer and the cover layer functions as a projection surface for the light signal.

12. A method for producing a sheetlike electronic component (2.0) as claimed in claim
2, comprising the following steps
- providing a cover layer (3.1) which is a non-conductive substrate
- applying a covering layer (3.3) to the front and/or rear side of the cover layer
- applying electronics comprising a display device (2.1) for generating a light signal, the energy source (2.2), and the conductor tracks (2.6) on the
rear side of the cover layer or the covering layer, wherein the display device is an OLED display device (2.1) and the electronics were applied at least partially, preferably completely, using a printing process, and
wherein the cover layer (3.1) is at least partially translucent, so that the light signal of the display device is scattered at the cover layer and the cover layer functions as a projection surface for the light signal.

13. A use of a sheetlike electronic component (2.0) as claimed in any one of claims 1- 10 for the design of products and packaging, in particular print and paper products, wherein the sheetlike electronic component is applied to a surface of the product or packaging using an adhesive.

14. A product
wherein
a sheetlike electronic component as claimed in any one of claims 1- 10 is attached to a surface of the product.

15. A product
wherein
the product comprises a surface (1.1) made of an at least partially translucent material which has an imprinting on one side,
wherein electronics comprising a display device (1.3) for generating light signals, an energy source (1.5), and a conductor track (1.4) are applied to the opposite side of the imprinting, so that the surface is used as a non-conductive substrate for the electronics, wherein the display device is an OLED display device and the electronics were applied at least partially, preferably completely, to the surface using a printing method, so that the surface represents a translucent cover layer for the electronics and the light signal of the display device is visible through the surface and scattered so that the surface functions as a projection surface for the light signal.

## Revendications

1. Module électronique plat (2.0)
comprenant un dispositif d'affichage pour générer un signal lumineux, une source d'énergie et une piste conductrice
dans lequel
le module comprend une strate inférieure (2.7) d'un substrat non conducteur, une strate médiane d'un composant électronique, comprenant le dispositif d'affichage (2.1), la source d'énergie (2.2) et la piste conductrice (2.6), dans lequel le dispositif d'affichage est un dispositif d'affichage OLED (2.1) et le composant électronique a été appliqué au moins partiellement, de préférence complètement, sur le substrat au moyen d'un procédé d'impression et une strate supérieure d'une couche de couverture imprimable (3.1), dans lequel la couche de couverture est au moins partiellement translucide, de sorte que le signal lumineux du dispositif d'affichage est diffusé sur la couche de couverture au moins partiellement translucide et la couche de couverture sert de surface de projection pour le signal lumineux et dans lequel le module électronique plat présente une épaisseur inférieure à 1 mm.

2. Module électronique plat (2.0) comprenant un dispositif d'affichage pour générer un signal lumineux, une source d'énergie et une piste conductrice
dans lequel
une strate d'un composant électronique comprenant le dispositif d'affichage (2.1), la source d'énergie (2.2) et la piste conductrice (2.6) est appliquée sur une strate supérieure d'une couche de couverture imprimable (3.1), qui est un substrat non conducteur, dans lequel le dispositif d'affichage est un dispositif d'affichage OLED et le composant électronique est au moins partiellement, de préférence complètement, appliqué sur la couche de couverture au moyen d'un procédé d'impression
et dans lequel la couche de couverture est au moins partiellement translucide, de sorte que le signal lumineux du dispositif d'affichage est diffusé sur la couche de couverture et la couche de couverture agit comme une surface de projection pour le signal lumineux et dans lequel le module électronique plat présente une épaisseur inférieure à 1 mm.

3. Module électronique plat (2.0) selon l'une des revendications précédentes
dans lequel
le module a une épaisseur inférieure à 0,3 mm.

4. Module électronique plat (3.0) selon l'une des revendications précédentes
dans lequel
le procédé d'impression est choisi dans un groupe comprenant le jet d'encre, la sérigraphie, l'impression flexographique, l'impression offset.

5. Module électronique plat (2.0) selon l'une des revendications précédentes
dans lequel
le dispositif d'affichage OLED (2.1) présente une cathode, une anode et un système de couches entre la cathode et l'anode, comprenant
- au moins une couche d'injection d'électrons proche de la cathode,
- au moins une couche de transport d'électrons
- au moins une couche optiquement active
- au moins une couche de transport de trous
- au moins une couche d'injection de trous à proximité de l'anode
dans lequel l'au moins une couche d'injection d'électrons et l'au moins une couche d'injection de trous limitent la diffusion vis-à-vis de l'eau et/ou de l'oxygène et
l'au moins une couche de transport d'électrons et l'au moins une couche de transport de trous représentent une barrière de diffusion vis-à-vis de l'eau et/ou de l'oxygène.

6. Module électronique plat (2.0) selon l'une des revendications précédentes
dans lequel
la source d'énergie (2.2) comprend une batterie, une cellule solaire organique et/ou un condensateur et/ou
les pistes conductrices (2.6) comprennent de l'argent, du cuivre et/ou du carbone comme matériau d'impression.

7. Module électronique plat (2.0) selon l'une des revendications précédentes
dans lequel
la couche de couverture (3.1) comprend des matériaux contenant de la cellulose, de préférence du papier et/ou du carton, de manière particulièrement préférée du papier calque, du papier ingraissable et/ou des films de préférence en polynaphtalate d'éthylène (PEN) et/ou poly téréphtalate d'éthylène (PET) et/ou
le substrat non conducteur (2.7) comprend du papier et/ou du PET.

8. Module électronique plat (2.0) selon l'une des revendications précédentes
dans lequel
entre la couche de couverture (3.1) et le composant électronique se trouve une couche de recouvrement supplémentaire non conductrice (3.3) qui présente un évidement pour le dispositif d'affichage.

9. Module électronique plat (2.0) selon l'une des revendications précédentes
dans lequel
le composant électronique comprend un interrupteur (2.5) pour activer le dispositif d'affichage et/ou
la couche de couverture comprend un évidement au-dessus d'une piste conductrice, dans lequel le contact de cette dernière avec un objet conducteur complète un circuit de sorte que le dispositif d'affichage est éclairé.

10. Module électronique plat (2.0) selon l'une des revendications précédentes
dans lequel
le composant électronique comprend un capteur (2.3), de préférence un capteur de lumière, et/ou
le composant électronique comprend un dispositif de commande électronique avec un ou plusieurs transistors.

11. Procédé de réalisation d'un module électronique plat (2.0) selon la revendication 1, comprenant les étapes suivantes
- fourniture d'un substrat non conducteur (2.7)
- application d'un composant électronique comprenant un dispositif d'affichage (2.1) pour générer des signaux lumineux, une source d'énergie (2.2) et des pistes conductrices (2.6) au substrat,
dans lequel le dispositif d'affichage est un dispositif d'affichage OLED (2.1) et le composant électronique a été appliqué au moins partiellement, de préférence complètement, au substrat au moyen d'un processus d'impression
- application d'une couche de couverture imprimable (3.1) au composant électronique, dans lequel la couche de couverture est au moins partiellement translucide de sorte que le signal lumineux du dispositif d'affichage est diffusé sur la couche de couverture et la couche de couverture agit comme une surface de projection pour le signal lumineux.

12. Procédé de fabrication d'un module électronique plat (2.0) selon la revendication 2 comprenant les étapes suivantes
- fourniture d'une couche de couverture (3.1) qui est un substrat non conducteur
- application d'une couche de recouvrement (3.3) à l'avant et/ou à l'arrière de la couche de couverture
- application du composant électronique comprenant un dispositif d'affichage (2.1) pour générer un signal lumineux, une source d'énergie (2.2) et les pistes conductrices (2.6) à l'arrière de la couche de couverture ou de la couche de recouvrement, dans lequel le dispositif d'affichage est un dispositif d'affichage OLED (2.1) et le composant électronique a été appliqué au moins partiellement, de préférence complètement, au moyen d'un processus d'impression et
dans lequel la couche de couverture (3.1) est au moins partiellement translucide de sorte que le signal lumineux du dispositif d'affichage est diffusé sur la couche de couverture et la couche de couverture agit comme une surface de projection pour le signal lumineux..

13. Utilisation d'un module électronique plat (2.0) selon l'une des revendications 1 à 10 pour la conception de produits et d'emballages, notamment de produits imprimés et papiers, dans lequel le module électronique plat est appliqué sur une surface du produit ou de l'emballage à l'aide d'un adhésif.

14. Produit
dans lequel
un module électronique plat selon l'une des revendications 1 à 10 est appliqué à une surface du produit.

15. Produit
dans lequel
le produit comprend une surface (1.1) en un matériau au moins partiellement translucide qui présente une impression sur une face,
dans lequel un composant électronique comprenant un dispositif d'affichage (1.3) pour générer des signaux lumineux, une source d'énergie (1.5) et une piste conductrice (1.4) est appliqué sur le côté opposé de l'impression, de sorte que la surface sert de substrat non conducteur pour le composant électronique, dans lequel le dispositif d'affichage est un dispositif d'affichage OLED et le composant électronique est appliqué au moins partiellement, de préférence complètement, à la surface au moyen d'un processus d'impression, de sorte que la surface représente une couche de couverture translucide pour le composant électronique et le signal lumineux du dispositif d'affichage est visible à travers la surface et diffusé de sorte que la surface agisse comme une surface de projection pour le signal lumineux.
